# EUROPÄISCHE PATENTSCHRIFT

(11) **EP 3 924 793 B1**
(45) Veröffentlichungstag und Bekanntmachung des Hinweises auf die Patenterteilung: **25.01.2023**
(21) Anmeldenummer: 20705024.6
(22) Anmeldetag: 10.02.2020
(51) Int. Cl.: G05B 23/02, G03F 7/20

(54) **STEUERUNGSSYSTEM, OPTISCHES SYSTEM UND VERFAHREN**
OPEN-LOOP CONTROL SYSTEM, OPTICAL SYSTEM AND METHOD
SYSTÈME DE COMMANDE, SYSTÈME OPTIQUE ET PROCÉDÉ

(30) Priorität: 12.02.2019 DE 102019201810
(43) Veröffentlichungstag der Anmeldung: 22.12.2021
(73) Patentinhaber: Carl Zeiss SMT GmbH, 73447 Oberkochen (DE)
(72) Erfinder: HOFFMANN, Malte, 73432 Aalen/Ebnat (DE); SCHULZ, Gunther, 89415 Lauingen (DE)
(74) Vertreter: Horn Kleimann Waitzhofer Patentanwälte PartG mbB
(86) Internationale Anmeldenummer: PCT/EP2020/053324
(87) Internationale Veröffentlichungsnummer: WO 2020/165091

(56) Entgegenhaltungen:
- EP-A2- 2 511 765
- DE-A1-102015 008 754
- "Linear Position Sensors for Prognostics", IP.COM JOURNAL, IP.COM INC., WEST HENRIETTA, NY, US, 30. Januar 2015 (2015-01-30), XP013166345, ISSN: 1533-0001

## Beschreibung

Die vorliegende Erfindung betrifft ein Steuerungssystem, insbesondere für ein optisches System oder eine Lithographieanlage, ein optisches System mit einem solchen Steuerungssystem und ein Verfahren zum Betreiben eines Steuerungssystems.

Bekannte Steuerungssysteme weisen eine Vielzahl von aktuierbaren Elementen auf, wobei es für einen Betrieb derartiger Systeme häufig auf eine genaue und/oder zeitkritische Ansteuerung der aktuierbaren Elemente ankommt. Ein Beispiel für ein solches Steuerungssystem ist eine Lithographieanlage für die Mikrolithographie.

Die Mikrolithographie wird zur Herstellung mikrostrukturierter Bauelemente, wie beispielsweise integrierter Schaltkreise, angewendet. Der Mikrolithographieprozess wird mit einer Lithographieanlage durchgeführt, welche ein Beleuchtungssystem und ein Projektionssystem aufweist. Das Bild einer mittels des Beleuchtungssystems beleuchteten Maske (Retikel) wird hierbei mittels des Projektionssystems auf ein mit einer lichtempfindlichen Schicht (Photoresist) beschichtetes und in der Bildebene des Projektionssystems angeordnetes Substrat, beispielsweise einen Siliziumwafer, projiziert, um die Maskenstruktur auf die lichtempfindliche Beschichtung des Substrats zu übertragen. Das Projektionssystem umfasst beispielsweise eine Vielzahl aktuierbarer optischer Bauelemente, wie Linsen oder Spiegel.

Ein Ausfall eines optischen Bauelements kann zu unerwarteten Verzögerungen in der Produktion und damit zu hohen Verlusten führen, weshalb es erwünscht ist, den Zustand des Systems möglichst genau zu überwachen. Es sind Überwachungssysteme bekannt, die mit Hilfe von spezifischen Sensoren den Zustand des Systems überwachen. Eine Schwierigkeit bei hochkomplexen Steuerungssystemen wie Lithographieanlagen können die Betriebsbedingungen darstellen, wenn eine solches System beispielsweise im Vakuum betrieben wird, da dann eine Kühlung elektronischer Bauteile, die Bestandteil des Überwachungssystems sind, aufwändig ist. Daher ist eine Rechenleistung innerhalb des Systems selbst häufig begrenzt, weshalb nicht alle verfügbaren Daten für Überwachung verarbeitet werden können.

EP 2 511 765 A1 offenbart eine Regelvorrichtung, die dazu eingerichtet ist, eine flächige Anordnung von individuell ansteuerbaren Strahlablenkungselementen zu regeln, mit der eine Pupillenfläche eines Beleuchtungssystems einer mikrolithographischen Projektionsbelichtungsanlage variabel ausleuchtbar ist, wobei sich durch jedes Strahlablenkungselement eine Ablenkung eines darauf auftreffenden Projektionslichtbündels in Abhängigkeit von einem an dem Strahlablenkungselement anliegenden Steuersignal erzielen lässt. Die Regelvorrichtung umfasst eine Messeinrichtung, die dazu eingerichtet ist, ein Messsignal zu erzeugen, einen modelbasierten Zustandsschätzer, der dazu eingerichtet ist, unter Verwendung des Messsignals einen geschätzten Zustandsvektor zu bestimmen, der die von dem Strahlablenkungselement hervorgerufene Ablenkung und deren zeitliche Ableitung repräsentiert, und einen Regler, der dazu eingerichtet ist, den geschätzten Zustandsvektor und einen Sollwert für die von dem Strahlablenkungselement hervorgerufene Ablenkung und deren zeitliche Ableitung zu verarbeiten und über eine Stellgröße das an dem Strahlablenkungselement anliegende Steuersignal zu steuern.

DE 10 2015 008754 A1 offenbart eine Vorrichtung zur Zustandsüberwachung eines servoventilgesteuerten Stellantriebs EHSA für die primäre Flugsteuerung, nämlich Höhenruder, Querruder, Seitenruder, Roll-Spoiler, Ground-Spoiler, Hauptrotorverstellung und/oder Heckrotorverstellung, in einem Fluggerät. Die Vorrichtung umfasst einen Zusatzsensor, der Daten eigens für die Zustandsüberwachung generiert, eine Prozessoreinheit zum Verarbeiten von Daten und zum Betreiben eines Systemmodells des Stellantriebs, wobei die Prozessoreinheit die Prozessoreinheit einer Ansteuerelektronik des Stellantriebs ist, und dazu ausgelegt ist, die Steuerung des Stellantriebs vorzunehmen, und mindestens einen Sensor zum Erfassen einer Stellgröße des Stellantriebs. Es ist ferner eine Speichereinheit vorgesehen, auf der charakteristische Daten über den Stellantrieb abgelegt sind, wobei die Prozessoreinheit dazu ausgelegt ist, auf Grundlage des Systemmodells mit Bezugnahme auf die Stellgröße des Stellantriebs und die charakteristischen Daten der Speichereinheit eine Zustandsüberwachung durchzuführen. Die auf der Speichereinheit abgelegten charakteristischen Daten sind Daten von Festigkeits-, Sicherheits-, und/oder Zuverlässigkeitsanalysen des Stellantriebs, die aus der Auslegungsphase des Stellantriebs bekannt sind, wobei die charakteristischen Daten typische strukturelle Merkmale und Grenzwerte beschreiben. Der EHSA umfasst die Ansteuerelektronik und eine Elektrohydraulik, wobei die Ansteuerelektronik eine Leistungselektronik, eine Antriebsregelung und die Zustandsüberwachung umfasst. Die Zustandsüberwachung umfasst die Speichereinheit, und die Elektrohydraulik umfasst ein Servo-Ventil, ein Schaltventil, Schiebergruppen, eine Bremse bzw. Dämpfung, einen Hydraulikzylinder, die Speichereinheit sowie den mindestens einen Sensor.

Der Artikel "Linear Position Sensors for Prognostics" von den Autoren Srinivasan, Ramamurthy, Araganji und Kathani, veröffentlicht am 30. Januar 2015, beschreibt ein Verfahren zum genauen Schätzen einer Restlebensdauer von Aktuatoren auf Basis einer Überwachung von Lasten während der Betriebszyklen und der Anzahl durchgeführter Bewegungen unter Verwendung von linearen Positionssensoren (LPS). Es wird eine adaptive Bewertung der Restlebensdauer von Aktuatoren mit LPS durchgeführt, indem ein Muster der Betriebszyklen erlernt wird und darauf basierend Empfehlungen für Gebrauchs- und Wartungsmaßnahmen gegeben werden.

Vor diesem Hintergrund besteht eine Aufgabe der vorliegenden Erfindung darin, ein verbessertes Steuerungssystem bereitzustellen.

Gemäß einem ersten Aspekt wird ein Steuerungssystem, insbesondere für ein optisches System, mit einem Stellglied, einem Messglied zum Erfassen von Stellgliedmessdaten des Stellglieds und einer Regelungseinheit zum Erzeugen eines Regelungssignals zum Regeln des Stellglieds in Abhängigkeit der erfassten Stellgliedmessdaten vorgeschlagen. Ferner ist eine Zustandsüberwachungseinheit zum Überwachen eines Zustands des Steuerungssystems in Abhängigkeit der erfassten Stellgliedmessdaten vorgesehen. Die Zustandsüberwachungseinheit umfasst eine erste Verarbeitungseinheit zum Erzeugen von vorverarbeiteten Zustandsdaten in Abhängigkeit der erfassten Stellgliedmessdaten und eines physikalischen Modells und/oder eines mathematischen Modells des Stellglieds oder in Abhängigkeit der erfassten Stellgliedmessdaten, eines physikalischen Modells und/oder eines mathematischen Modells des Stellglieds und des erzeugten Regelungssignals, und eine zweite Verarbeitungseinheit zum Ermitteln des Zustands des Steuerungssystems in Abhängigkeit der vorverarbeiteten Zustandsdaten.

Das vorgeschlagene Steuerungssystem hat gegenüber bekannten derartigen Systemen den Vorteil, dass Stellgliedmessdaten, die herkömmlicherweise zu Zwecken der Regelung erfasst und verwendet werden, auch für die Zustandsüberwachung des Steuerungssystems verwendet werden. Damit kann der Zustand des Steuerungssystems beispielsweise allein aufgrund der erfassten Stellgliedmessdaten überwacht werden, so dass spezifische Sensoren, wie Umgebungssensoren, zur Überwachung des Zustands entfallen können. Alternativ können die Stellgliedmessdaten zusätzlich zu Messdaten von vorhandenen Umgebungssensoren für die Zustandsüberwachung verwendet werden. Damit wird eine größere Datenbasis geschaffen, mittels derer sich der Zustand des Steuerungssystems genauer überwachen lässt. Insbesondere lassen sich die Stellgliedmessdaten zur Vorhersage eines zukünftigen Zustands heranziehen, beispielsweise zukünftig notwendig werdender Wartungsarbeiten, sogenanntes *predictive maintenance.* Dies ist eine bevorzugte Anwendung, da die Stellgliedmessdaten insbesondere unverarbeitete Rohdaten der jeweiligen Stellglieder sind, von denen sich ein Zustand des jeweiligen Stellglieds unverfälscht ableiten lässt.

Das Steuerungssystem ist insbesondere ein hochkomplexes System mit einer Vielzahl an zu steuernden Stellgliedern, beispielsweise eine Automationsanlage, eine Roboterfabrik, eine technische Großanlage, eine Forschungseinrichtung oder ein Teil einer Forschungseinrichtung, ein autonomes System, ein Kommunikationssystem und/oder eine Lithographieanlage.

Bei einer Lithographieanlage, die beispielsweise ein optisches System mit einer Vielzahl von steuerbaren optischen Elementen, insbesondere Mikrolinsenarrays und/oder Mikrospiegelarrays, aufweist, kommt es im laufenden Betrieb darauf an, dass jedes der optischen Elemente exakt steuerbar ist. Jede noch so kleine Fehlstellung eines optischen Elements kann zu einem Auflösungsverlust und/oder Belichtungsfehler führen, was beispielsweise negative Auswirkungen auf eine Funktion eines mit der Lithographieanlage hergestellten Mikrochips haben kann.

Insbesondere bei EUV-Lithographieanlagen kann einerseits nicht mehr mit transmissiven optischen Elementen gearbeitet werden, andererseits muss das Projektionsobjektiv evakuiert sein, so dass ein Strahlengang im Vakuum verläuft. Unter diesen Bedingungen ist es besonders schwierig, aktive Bauelemente, wie beispielsweise mikroelektronische Bauteile, zu betreiben, da diese im Betrieb eine gewisse Abwärme erzeugen, die sich aufgrund des Vakuums nicht über das umgebende Medium, insbesondere Luft, und dessen Konvektion abführen lässt. Ferner kann ein zu Verfügung stehender Bauraum begrenzt sein, weshalb aufwändige Kühlkonzepte, beispielsweise Flüssigkeitskühlungen, nicht ohne weiteres verwendbar sind. Bei derartigen Bedingungen ist es daher vorteilhaft, möglichst wenig Abwärme zu erzeugen, weshalb beispielsweise eine zur Verfügung stehende Rechenkapazität in diesem innersten Kern des Steuerungssystems begrenzt ist.

Dieser innerste Kern des Steuerungssystems kann nachfolgend auch als unterste Ebene oder als *Embedded System* bezeichnet werden. Das Embedded System lässt sich bei einer Lithographieanlage beispielsweise durch ein Vakuumgehäuse nach außen hin abgrenzen. Ferner kann unter dem Embedded System derjenige Teil des Steuerungssystems verstanden werden, innerhalb dessen eine Signalverarbeitung und/oder Signalübertragung proprietär ist. Das heißt, dass beispielsweise nur der Hersteller des Embedded System die Daten und/oder die Signale, die innerhalb des Embedded System erzeugt und/oder übertragen werden, verstehen kann. Eine Schnittstelle, die gemäß einem bestimmten, offengelegten Kommunikationsprotokoll kommuniziert, kann beispielsweise als Grenze des Embedded System angesehen werden.

Stellglieder umfassen insbesondere aktuierbare Elemente oder Aktuatoren, wie beispielsweise ein Mikrospiegel eines Mikrospiegelarrays mit zugehörigem Gelenk. Das Stellglied lässt sich insbesondere in zumindest einer Dimension einstellen oder verstellen, beispielsweise in eine Richtung verschieben, um eine Achse verkippen und/oder um eine Achse verdrehen. Jede verfügbare Einstell-Dimension bildet insofern einen Freiheitsgrad des Stellglieds. Eine Position des Stellglieds ist beispielsweise dann eindeutig definiert, wenn für jeden Freiheitsgrad ein Wert auf einer Einstell-Skala bekannt ist.

Die Stellglieder sind insbesondere mittels der Regelungseinheit einstellbar. Die Regelungseinheit kann auch als Motorsteuerung bezeichnet werden. Die Regelungseinheit erzeugt beispielsweise für jedes Stellglied des Steuerungssystems ein Regelungssignal. Sofern das Stellglied mehrere Freiheitsgrade aufweist, kann für jeden Freiheitsgrad ein unabhängiges Regelsignal vorgesehen sein. In Abhängigkeit des Regelungssignals verändert das Stellglied seine Einstellung, insbesondere seine Position. Beispielsweise weist das Stellglied eine von einer Stromstärke abhängige Position auf, wobei die Stromstärke insbesondere von einer Stromquelle in Abhängigkeit eines Tastverhältnisses bereitgestellt wird. Dann kann die Regelungseinheit insbesondere das Tastverhältnis als das Regelungssignal erzeugen. Ein Steuerungssystem kann insbesondere mehrere Regelungseinheiten aufweisen. Vorzugsweise ist eine jeweilige Regelungseinheit bei dem oder den zu regelnden Stellgliedern angeordnet.

Wenigstens ein Stellglied des Steuerungssystems weist ein zugeordnetes Messglied auf, das zum Erfassen von Stellgliedmessdaten des Stellglieds eingerichtet ist. Ein Messglied kann beispielsweise auch als Geber, Messumformer oder Transmitter bezeichnet werden. Das Messglied erfasst die Stellgliedmessdaten beispielsweise in Abhängigkeit einer Position des Stellglieds bezüglich eines bestimmten Freiheitsgrads. Ein solches Messglied kann auch als Positionssensor bezeichnet werden, wobei der Positionssensor beispielsweise eine Ortsauflösung im nm-Bereich aufweist. Die Stellgliedmessdaten repräsentieren insbesondere eine tatsächliche Einstellung oder Position des Stellglieds. Daher werden die Stellgliedmessdaten der Regelungseinheit als Eingangswerte für die Regelung bereitgestellt.

Die Stellgliedmessdaten können als ein analoges oder auch als ein digitales Signal von dem Messglied erzeugt werden. Das Messglied erzeugt die Stellgliedmessdaten beispielsweise mit einem Takt von 10 kHz. Sofern die Stellgliedmessdaten als ein analoges Signal erzeugt werden, lässt sich dieses beispielsweise von einem Analog-Digital-Wandler in ein digitales Signal umwandeln, wobei eine Abtastrate beispielsweise bei 100 kHz liegt.

Es kann auch vorgesehen sein, dass ein einzelnes Messglied einer Mehrzahl von Stellgliedern zugeordnet ist. Dann kann das Messglied dazu eingerichtet sein, für jedes zugeordnete Stellglied Stellgliedmessdaten zu erzeugen und als ein separates Signal auszugeben.

Die Zustandsüberwachungseinheit ist zum Überwachen des Zustands des Steuerungssystems in Abhängigkeit der Stellgliedmessdaten eingerichtet. Die Zustandsüberwachungseinheit kann hardwaretechnisch und/oder softwaretechnisch implementiert sein. Bei einer hardwaretechnischen Implementierung kann die Zustandsüberwachungseinheit zum Beispiel als Computer oder als Mikroprozessor ausgebildet sein. Bei einer softwaretechnischen Implementierung kann die Zustandsüberwachungseinheit als Computerprogrammprodukt, als eine Funktion, als eine Routine, als Teil eines Programmcodes oder als ausführbares Objekt ausgebildet sein. Die Zustandsüberwachungseinheit kann ganz oder teilweise Bestandteil des Embedded System, das heißt der untersten Ebene des Steuerungssystems, sein.

Unter einem Zustand des Steuerungssystems kann ein globaler Zustand, wie ein Gesamtzustand des Steuerungssystems, aber auch ein Zustand eines einzelnen Stellglieds oder mehrerer Stellglieder verstanden werden. Der Zustand kann beispielsweise als ein Parameter, ein Satz von Parametern, als Skalar, als Vektor, als Tensor, als Skalarfeld, als Vektorfeld und/oder als Tensorfeld repräsentiert werden. Der Zustand kann ferner einen aktuellen Zustand und/oder einen zukünftigen Zustand umfassen. Ein jeweiliger Zustand kann auch vergangene Zustände umfassen oder berücksichtigen.

Der Zustand umfasst insbesondere von den Stellgliedmessdaten abgeleitete Größen. Ein Beispiel hierfür ist eine gesamte von einem Aktuator zurückgelegte Wegstrecke seit der Aktuator in Betrieb genommen wurde. Ferner kann von den Stellgliedmessdaten beispielsweise auch auf Umwelteinflüsse, wie beispielsweise angeregte Vibrationen oder eine Temperatur, geschlossen werden.

Unter der Überwachung des Zustands wird insbesondere verstanden, dass die Zustandsüberwachungseinheit einen jeweiligen Zustand des Steuerungssystems ermittelt. Unter Ermitteln wird insbesondere verstanden, dass die Zustandsüberwachungseinheit die Stellgliedmessdaten verarbeitet, beispielsweise speichert, analysiert und/oder Berechnungen in Abhängigkeit der Stellgliedmessdaten durchführt. Insbesondere können die Stellgliedmessdaten als Eingangsgröße für physikalische und/oder mathematische Modelle verwendet werden, wobei als Ausgangsgröße beispielsweise ein Schätzwert und/oder eine physikalische Messgröße erhalten wird. Insbesondere ist die Zustandsüberwachungseinheit dazu eingerichtet, die derart erhaltenen Ausgangsgrößen an eine weitere Einheit auszugeben und/oder diese abzuspeichern.

Ferner kann unter Überwachen verstanden werden, dass die Zustandsüberwachungseinheit den ermittelten Zustand mit einem erwarteten Zustand und/oder mit einem vorbestimmten Zustand, beispielsweise einem Grenzwert, vergleicht. In Abhängigkeit des Vergleichs kann insbesondere vorgesehen sein, dass die Zustandsüberwachungseinheit einen Alarm oder einen Hinweis erzeugt und ausgibt.

Vorzugsweise ist die Zustandsüberwachungseinheit zur Überwachung des Zustands in Abhängigkeit des von der Regelungseinheit erzeugten Regelungssignals eingerichtet. Insbesondere kann die Zustandsüberwachungseinheit das Regelungssignal für das Stellglied und die von dem zugeordneten Messglied erfassten Stellgliedmessdaten miteinander koppeln oder korrelieren. Aus derart korrelierten Daten lässt sich besonders einfach erkennen, ob das Stellglied entsprechend einer ursprünglichen Spezifikation oder Kennlinie arbeitet. Damit lassen sich bereits frühzeitig Verschleißerscheinungen erkennen und daher zukünftig notwendige Wartungsmaßnahmen besser voraussagen und/oder planen.

Der Zustand des vorgeschlagenen Steuerungssystems lässt sich insbesondere ohne zusätzliche Sensoren und nur in Abhängigkeit der Stellgliedmessdaten überwachen, weshalb eine Komplexität des Steuerungssystems reduziert werden und das Steuerungssystem daher einfacher aufgebaut werden kann, wodurch sich Kosten einsparen lassen. Weiterhin hat das vorgeschlagene Steuerungssystem den Vorteil, dass die Zustandsüberwachung auf Basis der ursprünglichen Stellgliedmessdaten erfolgt, noch bevor eine Datenreduktion erfolgte

Die Zustandsüberwachungseinheit umfasst eine erste Verarbeitungseinheit zum Erzeugen von vorverarbeiteten Zustandsdaten in Abhängigkeit der erfassten Stellgliedmessdaten und eines physikalischen Modells und/oder eines mathematischen Modells des Stellglieds, oder in Abhängigkeit der erfassten Stellgliedmessdaten, eines physikalischen Modells und/oder eines mathematischen Modells des Stellglieds und des erzeugten Regelungssignals, und umfasst eine zweite Verarbeitungseinheit zum Ermitteln des Zustands des Steuerungssystems in Abhängigkeit der vorverarbeiteten Zustandsdaten. Insbesondere die erste Verarbeitungseinheit ist Teil des Embedded System und damit auf der untersten Ebene des Steuerungssystems angeordnet. Damit unterliegt die erste Verarbeitungseinheit den möglicherweise hohen Anforderungen bezüglich Raumbedarf, Energieverbrauch, Abwärme und/oder weitere Immissionen. Die zweite Verarbeitungseinheit ist vorzugsweise auf einer höheren Ebene des Steuerungssystems angeordnet, für die nicht die gleichen strengen Anforderungen gelten. Durch diese Aufteilung der Zustandsüberwachungseinheit lässt sich erreichen, dass einerseits alle Rohdaten für die Zustandsüberwachung zur Verfügung stehen oder verwendet werden können, andererseits aber rechenintensive Auswertungen zeitlich nachgelagert außerhalb des Embedded System erfolgen können.

Die größte Rohdatenmenge wird während des laufenden Betriebs des Steuerungssystems auf der untersten Ebene, in dem Embedded System, erzeugt, da dort beispielsweise die Stellglieder, die Messglieder und die Regelungseinheit angeordnet sind. Insbesondere ist die Rohdatenmenge, die pro Zeiteinheit erzeugt wird, das heißt die Rohdatenrate, so hoch, dass diese sich aufgrund der technischen Randbedingungen nicht vollständig aus dem Embedded System heraus in externe Systeme übertragen lässt. Die technischen Randbedingungen sind die teilweise hohen Anforderungen, die für das Embedded System gelten. Darunter fällt beispielsweise auch, dass eine Datenübertragung nach außen nicht beliebig skalierbar ist, da auch die hierfür notwendigen Sender/Empfänger sowie Leitungen entsprechend hohen Anforderungen gerecht werden müssen. Daher kann eine zur Verfügung stehende Bandbreite für die Datenübertragung begrenzt sein.

Die erste Verarbeitungseinheit ist daher insbesondere zum Vorverarbeiten der Rohdaten eingerichtet, um eine Datenmenge, die aus dem Embedded System heraus an die zweite Verarbeitungseinheit übertragen wird, zu reduzieren. Unter Vorverarbeiten wird insbesondere verstanden, dass die erste Verarbeitungseinheit die Stellgliedmessdaten und/oder das Regelungssignal empfängt und beispielsweise einfache mathematische Operationen, wie eine Mittelwertbildung, einen Gradienten, eine Summierung, einen Vergleich und/oder eine Multiplikation durchführt. Als Ergebnis der Vorverarbeitung durch die erste Verarbeitungseinheit erzeugt diese vorverarbeitete Zustandsdaten. Die vorverarbeiteten Zustandsdaten werden insbesondere an die zweite Verarbeitungseinheit übertragen. Die vorverarbeiteten Zustandsdaten weisen insbesondere eine Datenrate auf, die deutlich geringer ist als die Rohdatenrate, beispielsweise nur 10%, bevorzugt nur 1% davon beträgt.

Die zweite Verarbeitungseinheit weist vorzugsweise eine deutlich höhere Rechenleistung, insbesondere eine zeitunkritische Rechenleistung, als die erste Verarbeitungseinheit auf und ist dazu eingerichtet, in Abhängigkeit der vorverarbeiteten Zustandsdaten den Zustand des Steuerungssystems zu ermitteln. Hierfür kann die zweite Verarbeitungseinheit dazu eingerichtet sein, die vorverarbeiteten Zustandsdaten zu speichern, zu analysieren und/oder Berechnungen mit diesen durchzuführen. Insbesondere können die vorverarbeiteten Zustandsdaten als Eingangsgröße für physikalische und/oder mathematische Modelle verwendet werden, wobei als Ausgangsgröße beispielsweise ein Schätzwert und/oder eine physikalische Messgröße erhalten wird. Insbesondere ist die zweite Verarbeitungseinheit dazu eingerichtet, die derart erhaltenen Ausgangsgrößen an eine weitere Einheit auszugeben und/oder diese abzuspeichern.

In Ausführungsformen kann die zweite Verarbeitungseinheit dazu eingerichtet sein, die erste Verarbeitungseinheit anzusteuern, so dass diese beispielsweise die vorverarbeiteten Zustandsdaten auf eine unterschiedliche Weise erzeugt, beispielsweise mittels einer anderen Berechnungsmethode.

Gemäß einer weiteren Ausführungsform des Steuerungssystems ist die erste Verarbeitungseinheit dazu eingerichtet, die erfassten Stellgliedmessdaten kontinuierlich, insbesondere synchron zur Erfassung der Stellgliedmessdaten durch das Messglied, zu erfassen und zu verarbeiten.

Diese Ausführungsform ist vorteilhaft, da hiermit sichergestellt ist, dass alle Stellgliedmessdaten für die Zustandsüberwachung Verwendung finden. Sofern die Daten als digitale Daten vorliegen wird hierunter beispielsweise verstanden, dass jedes Bit, insbesondere der Wert jedes Bits, das durch das Messglied oder einen Analog-Digital-Wandler erzeugt wird, bei dem Erzeugen der vorverarbeiteten Zustandsdaten berücksichtigt wird. Unter einem Erfassen der erfassten Stellgliedmessdaten durch die erste Verarbeitungseinheit ist ein Entgegennehmen der erfassten Stellgliedmessdaten zu verstehen. Kontinuierlich ist insbesondere dahingehend zu verstehen, dass ein Erfassen der erfassten Stellgliedmessdaten durch die erste Verarbeitungseinheit ohne eine zeitliche Unterbrechung so lange erfolgt, wie das Messglied die Stellgliedmessdaten erfasst. Dabei kann vorgesehen sein, dass die erfassten Stellgliedmessdaten teilweise gepuffert werden, bevor die vorverarbeiteten Zustandsdaten erzeugt werden.

Gemäß einer weiteren Ausführungsform des Steuerungssystems ist die erste Verarbeitungseinheit dazu eingerichtet, die vorverarbeiteten Zustandsdaten in Abhängigkeit der erfassten Stellgliedmessdaten im laufenden Betrieb des Steuerungssystems zu erzeugen.

Diese Ausführungsform ist vorteilhaft, da kein besonderer Betriebsmodus, beispielsweise ein Testbetrieb, notwendig ist, um den Zustand des Steuerungssystems zu ermitteln und/oder zu überwachen. Unter dem laufenden Betrieb wird insbesondere verstanden, dass das Steuerungssystem gemäß einem Regelbetrieb, für den das Steuerungssystem vorgesehen ist, betrieben wird. Dies kann insbesondere ein produktiver Betrieb sein.

Bei einer Lithographieanlage ist der laufende Betrieb beispielsweise ein Produktionsbetrieb, wobei insbesondere auch während einer Belichtung die Stellgliedmessdaten und/oder das Regelungssignal erfasst und verarbeitet werden. Es werden insofern permanent während des Betriebs die vorverarbeiteten Zustandsdaten erzeugt.

Vorzugsweise ist auch die zweite Verarbeitungseinheit dazu eingerichtet, den Zustand des Steuerungssystems in Abhängigkeit der vorverarbeiteten Zustandsdaten im laufenden Betrieb zu ermitteln.

Gemäß einer weiteren Ausführungsform weist das Steuerungssystem eine Ansteuerungseinheit zum Erzeugen von Stellgliedansteuerungsdaten in Abhängigkeit eines aktuell durchgeführten Betriebsprogramms einer Anzahl von Betriebsprogrammen auf. Die Regelungseinheit ist zum Erzeugen des Regelungssignals in Abhängigkeit der Stellgliedansteuerungsdaten eingerichtet, wobei die erste Verarbeitungseinheit zum Erzeugen der vorverarbeiteten Zustandsdaten in Abhängigkeit des aktuell durchgeführten Betriebsprogramms eingerichtet ist.

Die Ansteuerungseinheit kann auch als Positionssteuerung bezeichnet werden. Die Ansteuerungseinheit kann als selbständige Einheit oder auch als Teil der Regelungseinheit ausgebildet sein. Die Stellgliedansteuerungsdaten umfassen insbesondere für jedes Stellglied individuelle Soll-Positionsdaten. Die Regelungseinheit empfängt die Soll-Positionsdaten und übersetzt diese in ein entsprechendes Regelungssignal für ein jeweiliges Stellglied.

Die Anzahl von Betriebsprogrammen umfasst insbesondere einen Regelbetrieb, einen Testbetrieb und/oder auch einen Notbetrieb.

Ein Testbetrieb kann insbesondere zum Testen des Steuerungssystems vorgesehen sein. Der Testbetrieb kann besonders hilfreich sein, um den Zustand des Steuerungssystems und/oder einzelner Stellglieder zu ermitteln. Der Testbetrieb lässt sich beispielsweise manuell und/oder automatisch auslösen, beispielsweise in regelmäßigen Zeitabständen. Der Testbetrieb kann beispielsweise in Produktionspausen durchgeführt werden. Der Testbetrieb kann auch auf bestimmte Bereiche des Steuerungssystems beschränkt sein. Beispielsweise umfasst ein Steuerungssystem zwei Bereiche, die abwechselnd aktiv sind, da das eine beispielsweise eine Vorverarbeitung und das andere eine Nachverarbeitung durchführt, so dass der eine Bereich jeweils auf den anderen wartet. Dann kann während dieser Leerlaufphase eines der Bereiche ein Test mit diesem Bereich durchgeführt werden.

Die erste Verarbeitungseinheit erzeugt die vorverarbeiteten Zustandsdaten in Abhängigkeit des jeweiligen Betriebsprogramms. Beispielsweise kann vorgesehen sein, dass die vorverarbeiteten Zustandsdaten im laufenden Betrieb gemäß einem ersten Vorverarbeitungsverfahren erzeugt werden und während eines Testbetriebs gemäß einem zweiten Vorverarbeitungsverfahren erzeugt werden. Insbesondere kann es vorgesehen sein, dass in einem bestimmten Betriebsprogramm die vorverarbeiteten Zustandsdaten identisch zu den Rohdaten sind. Beispielsweise umfasst die erste Verarbeitungseinheit einen Zwischenspeicher, in dem die Rohdaten zwischengespeichert werden, bis diese nach außen übertragen werden.

Gemäß einer weiteren Ausführungsform des Steuerungssystems weist dieses einen Umgebungssensor zum Erfassen von Umgebungssensordaten auf, wobei die erste Verarbeitungseinheit zum Erzeugen der vorverarbeiteten Zustandsdaten in Abhängigkeit der erfassten Umgebungssensordaten eingerichtet ist.

Diese Ausführungsform ist besonders vorteilhaft, um möglichst viele Informationen bezüglich des Steuerungssystems zur Überwachung des Zustands zu verbinden.

Umgebungssensoren können Sensoren jeglicher Art sein, beispielsweise Temperatur-, Druck-, Gas-, Beschleunigungs-, Strahlungs-, Strom-, Spannungs- und/oder Strömungssensoren. Ein Umgebungssensor ist insbesondere ein Sensor, dessen erfasste Daten nicht für die Regelung der durch die Regelungseinheit geregelten Stellglieder verwendet werden. Die von dem Umgebungssensor erfassten Umgebungssensordaten können sich auf ein Stellglied, ein Messglied, eine Anzahl mehrerer Stell- oder Messglieder und/oder auf passive Elemente des Steuerungssystems beziehen.

Die Berücksichtigung der erfassten Umgebungssensordaten bereits bei der Erzeugung der vorverarbeiteten Zustandsdaten kann besonders vorteilhaft sein, um eine Datenrate der vorverarbeiteten Zustandsdaten gering zu halten. Beispielsweise kann die zur Vorverarbeitung angewandte Methode in Abhängigkeit der erfassten Umgebungssensordaten ausgewählt werden.

Die erfassten Umgebungssensordaten können vorteilhaft selbst ein Teil der vorverarbeiteten Zustandsdaten sein, insbesondere auch ohne vorverarbeitet zu werden. Insofern können die erfassten Umgebungssensordaten als Rohdaten der zweiten Verarbeitungseinheit bereitgestellt werden.

Gemäß einer weiteren Ausführungsform des Steuerungssystems ist das Messglied dazu eingerichtet, die Stellgliedmessdaten mit einer Frequenz von 1 kHz bis 10 kHz, bevorzugt bis 100 kHz, weiter bevorzugt bis 1 MHz zu erfassen.

Die Erfassungsfrequenz des Messglieds hängt insbesondere von dem Einsatzzweck des zugeordneten Stellglieds ab. Bei Hochgeschwindigkeitsanwendungen ist eine hohe Frequenz vorteilhaft, wobei eine hohe Erfassungsfrequenz insbesondere eine hohe Rohdatenrate zur Folge hat.

Gemäß einer weiteren Ausführungsform des Steuerungssystems ist die Regelungseinheit dazu eingerichtet, das Regelungssignal mit einer Frequenz von 1 kHz bis 10 kHz, bevorzugt bis 100 kHz, weiter bevorzugt bis 1 MHz zu erzeugen.

Die Taktfrequenz des Regelungssignals hängt insbesondere von dem Einsatzzweck des damit geregelten Stellglieds ab. Bei Hochgeschwindigkeitsanwendungen ist eine hohe Frequenz vorteilhaft.

Vorzugsweise ist eine Erfassungsfrequenz des Messglieds eine Größenordnung größer als die Taktfrequenz des Regelungssignals.

Gemäß einer weiteren Ausführungsform des Steuerungssystems ist die erste Verarbeitungseinheit dazu eingerichtet, die vorverarbeiteten Zustandsdaten mit einer Datenrate zu erzeugen, die höchstens 10%, bevorzugt höchstens 1% einer Datenrate der erfassten Stellgliedmessdaten beträgt, wobei jedes einzelne erfasste Stellgliedmessdatum in die vorverarbeiteten Zustandsdaten eingeht.

Diese Ausführungsform ermöglicht es vorteilhaft, dass auch bei einer hohen Stellgliedmessdatenrate und begrenzter Übertragungsbandbreite aus dem Embedded System heraus alle erfassten Stellgliedmessdaten bei der Zustandsüberwachung berücksichtigt werden. Die erste Verarbeitungseinheit ist somit zur Reduktion der Datenrate eingerichtet, ohne Daten zu verwerfen. Vorzugsweise ermittelt und/oder berechnet die erste Verarbeitungseinheit bestimmte abgeleitete Daten aus den erfassten Stellgliedmessdaten und gibt diese als die vorverarbeiteten Zustandsdaten aus.

In einer Ausführungsform des Steuerungssystems ist die erste Verarbeitungseinheit zum Erzeugen der vorverarbeiteten Zustandsdaten in Abhängigkeit der erfassten Stellgliedmessdaten und eines physikalischen Modells des jeweiligen Stellglieds der Vielzahl eingerichtet.

Ein physikalisches Modell umfasst beispielsweise eine mathematische Beschreibung physikalischer Zusammenhänge und/oder physikalische Parameter. Ein einfaches Modell ist beispielsweise die Beschreibung eines Federpendels, das durch eine Masse, eine Federkonstante sowie ein Dämpfungsterm beschrieben wird. Für unterschiedliche Stellglieder können, in Abhängigkeit der Art jeweiligen Stellglieds, unterschiedliche physikalische Modelle zur Anwendung kommen.

Derartige physikalische Modelle erlauben es vorteilhaft, aus einer großen Datenmenge einen oder mehrere charakteristische Werte für ein jeweiliges System zu ermitteln oder abzuleiten, die insbesondere eine physikalische Dimension oder Bedeutung aufweisen können. Weiterhin kann das physikalische Modell statistische Methoden umfassen, so dass beispielsweise ausgehend von Werteverteilungen Momente dieser Verteilungen ermittelt werden können, beispielsweise eine Standardabweichung, eine Varianz und dergleichen mehr.

Gemäß einer weiteren Ausführungsform des Steuerungssystems umfasst das Stellglied einen Aktuator zum Einstellen einer Position eines Elements, insbesondere einen Lorentzaktuator, und das Messglied umfasst einen Positionssensor zum Erfassen der Position des Elements, insbesondere ein Interferometer und/oder eine CCD-Kamera.

Vorzugsweise lässt sich eine Position des Elements, das beispielsweise ein optisches Element, wie ein Spiegel oder eine Linse, ist, mit einer Genauigkeit von mindestens 1 µm in einer lateralen Richtung und mit einer Genauigkeit von mindestens 10 µrad in einer Drehrichtung einstellen. Der Positionssensor ist vorzugsweise zum Erfassen der Position mit mindestens der gleichen Genauigkeit, vorzugsweise mit einer 10-fach höheren Genauigkeit eingerichtet.

Je höher eine Einstellgenauigkeit der Stellglieder ist, umso höher sollte auch die Auflösung der Messglieder sein, vorzugsweise mindestens gleich hoch. Unter einer Position wird vorliegend beispielsweise eine Verkippung, eine Verdrehung oder auch eine Verschiebung verstanden.

Beispielsweise kann aus den Stellgliedmessdaten, sofern diese eine hinreichend hohe räumliche und/oder zeitliche Auflösung aufweisen, auf eine aktuelle Temperatur des jeweiligen Stellglieds geschlossen werden.

Gemäß einer weiteren Ausführungsform des Steuerungssystems sind die Regelungseinheit und die Zustandsüberwachungseinheit, insbesondere die erste Verarbeitungseinheit, auf einem SoC (System-on-Chip) und/oder auf einem FPGA (Field-programmable-gate-array) integriert, wobei bevorzugt das SoC oder das FPGA auf einer untersten Ebene des Steuerungssystems angeordnet sind.

Die unterste Ebene des Steuerungssystems entspricht dem Embedded System. SoCs oder FPGAs haben den Vorteil, dass sie eine hohe Integrationsdichte aufweise können, einen vergleichsweise geringen Energiebedarf und damit eine geringe Abwärme aufweisen, und durch spezifische Programmierung dennoch eine hohe Rechenleistung aufweisen.

Gemäß einer weiteren Ausführungsform des Steuerungssystems ist die zweite Verarbeitungseinheit auf einer höheren Ebene als die unterste Ebene des Steuerungssystems angeordnet, wobei die erste Verarbeitungseinheit zum Übertragen der vorverarbeiteten Zustandsdaten an die zweite Verarbeitungseinheit mittels einer Datenverbindung eingerichtet ist.

Diese Ausführungsform weist den Vorteil auf, dass die zweite Verarbeitungseinheit im Vergleich mit der ersten Verarbeitungseinheit deutliche geringere Anforderungen bezüglich eines Platzbedarfs und/oder eines Energieverbrauchs einzuhalten hat. Beispielsweise ist die höhere Ebene außerhalb eines Vakuums angeordnet. Dann können elektronische Komponenten mit Luft gekühlt werden, was besonders einfach ist.

Die Datenverbindung ist vorzugsweise eine gegen Störungen durch elektromagnetische Felder abgeschirmte Datenleitung. Diese kann beispielsweise eine elektrische Verbindung, wie ein Twisted-Pair-Kabel oder ein Koaxialkabel umfassen. Die Datenverbindung ist vorzugsweise zur seriellen Übertragung der Daten eingerichtet, aber auch parallele Übertragungsprotokolle können verwendet werden.

Außerdem kann die zweite Verarbeitungseinheit große zugeordnete Datenspeicher aufweisen. Ein derartiger großer Datenspeicher umfasst beispielsweise wenigstens 100 GB an Speicherplatz, vorzugsweise wenigstens 1 TB. Vorzugsweise ist der Speicherplatz so groß, dass die vorverarbeiteten Zustandsdaten einer kompletten Produktionsphase darin abgelegt werden können. Diese lassen sich dann beispielsweise auch zeitlich nachgelagert analysieren.

Gemäß einer weiteren Ausführungsform des Steuerungssystems ist die zweite Verarbeitungseinheit dazu eingerichtet, die vorverarbeiteten Zustandsdaten mittels eines Maschinen-Lern-Algorithmus und/oder statistischer Auswertemethoden zu analysieren.

Diese Ausführungsform ist besonders vorteilhaft, wenn komplexe Zusammenhänge in einer Vielzahl von Daten erkannt werden sollen. Beispielsweise lassen sich auf diese Weise Korrelationen zwischen verschiedenen Stellgliedern, Stellgliedmessdaten, und/oder Umgebungssensordaten erkennen, die für den weiteren Betrieb berücksichtigt werden können. Insbesondere lassen sich auch Schwachstellen des Steuerungssystems erkennen und bei Bedarf ausbessern. Eine Spektralanalyse von zeitlichen Positionsdaten kann beispielsweise Hinweise auf Resonanzfrequenzen und/oder Anregungen geben, die zur Verbesserung einer Genauigkeit daraufhin angepasst oder vermieden werden können.

Gemäß einer weiteren Ausführungsform des Steuerungssystems ist die Zustandsüberwachungseinheit dazu eingerichtet, in Abhängigkeit des überwachten Zustands oder der vorverarbeiteten Zustandsdaten einen zukünftigen Zustand des Steuerungssystems, insbesondere einen Fehlerzustand oder einen eine Wartung erforderlich machenden Zustand eines optischen Systems, zu ermitteln.

Beispielsweise ist die Zustandsüberwachungseinheit dazu eingerichtet, eine sogenannte *predictive maintenance analysis* auf Basis der vorverarbeiteten Zustandsdaten durchzuführen. Dabei wird auf der Basis der erfassten Daten, insbesondere der Stellgliedmessdaten, eine Vorhersage über zukünftige Ausfälle getroffen. Eine notwendige Wartung lässt sich so besser planen, insbesondere in den laufenden Betrieb integrieren. Weiterhin können eventuell benötigte Ersatzteile gezielt und termingerecht beschafft werden. Ein finanzielles Risiko aufgrund eines plötzlichen Betriebsausfalls kann mit dieser Methode deutlich reduziert werden. Aufgrund der Vielzahl an für die Zustandsüberwachung verfügbaren Daten bei dem vorgeschlagenen Steuerungssystem kann der Zustand des Steuerungssystems insgesamt, der Zustand einzelner Stellglieder individuell und/oder Bauteile umfassend eine Anzahl von Stellgliedern, deutlich genauer ermittelt werden, als dies bei Verwendung von ausschließlich Umgebungssensoren der Fall wäre. Zudem sind die Stellgliedmessdaten stets aktuell und beschreiben damit einen aktuellen Ist-Zustand, wobei aus einem zeitlichen Verlauf der Ist-Zustände beispielsweise eine Verschleißkurve ableitbar ist, die Auskunft über einen Verschleißzustand und damit beispielsweise über eine verbleibende Restdauer bis zu einem Ausfall geben kann.

In Ausführungsformen ist die Zustandsüberwachungseinheit ferner dazu eingerichtet, in Abhängigkeit des ermittelten zukünftigen Zustands eine vorbestimmte Aktion durchzuführen.

Vorzugsweise gibt die Zustandsüberwachungseinheit einen entsprechenden Hinweis oder eine Warnung aus, wenn ein bestimmter Grenzwert bezüglich eines ermittelten zukünftigen Zustands über- oder unterschritten wird.

Die Zustandsüberwachungseinheit kann auch dazu eingerichtet sein, den ermittelten Zustand, insbesondere den ermittelten zukünftigen Zustand, und/oder eine daraus abgeleitete Größe auszugeben, beispielsweise an die Regelungseinheit und/oder eine Positionsregelung. Diese kann dann dazu eingerichtet sein, in Abhängigkeit der von der Zustandsüberwachungseinheit empfangenen Daten eine Regelungscharakteristik anzupassen. Dies kann beispielsweise als eine zustandsadaptive Regelung bezeichnet werden. Insbesondere kann die Regelung bei aktuierbaren Elementen derart erfolgen, dass bestimmte Positionen eines Stellmotors nach Möglichkeit zukünftig vermieden werden.

Gemäß einem zweiten Aspekt der vorliegenden Erfindung wird ein optisches System, insbesondere eine Lithographieanlage, mit einem Steuerungssystem gemäß dem ersten Aspekt vorgeschlagen.

Das Steuerungssystem umfasst hierbei insbesondere zumindest ein Stellglied ein zum Ansteuern eines steuerbaren optischen Elements. Mikrospiegelarrays oder Mikrolinsenarrays sind Beispiele für ein steuerbares optisches Element.

Gemäß einem dritten Aspekt wird ein Verfahren zum Betreiben eines Steuerungssystems gemäß dem ersten Aspekt oder eines optischen Systems gemäß dem zweiten Aspekt vorgeschlagen. In einem ersten Verfahrensschritt werden Stellgliedmessdaten erfasst. In einem zweiten Verfahrensschritt wird ein Regelungssignal in Abhängigkeit der erfassten Stellgliedmessdaten erzeugt. In einem dritten Verfahrensschritt wird der Zustand des Steuerungssystems oder des optischen Systems in Abhängigkeit der erfassten Stellgliedmessdaten überwacht. Dies umfasst, dass vorverarbeitete Zustandsdaten in Abhängigkeit der erfassten Stellgliedmessdaten und eines physikalischen Modells und/oder eines mathematischen Modells des Stellglieds, oder in Abhängigkeit der erfassten Stellgliedmessdaten, eines physikalischen Modells und/oder eines mathematischen Modells des Stellglieds und des erzeugten Regelungssignals erzeugt werden und der Zustand des Steuerungssystems oder des optischen Systems in Abhängigkeit der vorverarbeiteten Zustandsdaten ermittelt wird.

Dieses Verfahren ist besonders vorteilhaft mit dem Steuerungssystem gemäß dem ersten Aspekt oder einer der Ausführungsformen sowie mit dem optischen System gemäß dem zweiten Aspekt durchführbar.

Das Verfahren kann weitere, optionale Verfahrensschritte umfassen. Insbesondere kann vorgesehen sein, dass vorverarbeitete Zustandsdaten in Abhängigkeit der erfassten Stellgliedmessdaten mittels einer ersten Verarbeitungseinheit erzeugt werden, die vorverarbeiteten Zustandsdaten dann über eine Kommunikationsverbindung an eine zweite Verarbeitungseinheit übermittelt werden, wobei die zweite Verarbeitungseinheit einen Zustand des Steuerungssystems in Abhängigkeit der vorverarbeiteten Zustandsdaten ermittelt.

Gemäß einer Ausführungsform des Verfahrens umfasst dieses ferner ein Warten des optischen Systems in Abhängigkeit des überwachten Zustands.

"Ein" ist vorliegend nicht zwingend als beschränkend auf genau ein Element zu verstehen. Vielmehr können auch mehrere Elemente, wie beispielsweise zwei, drei oder mehr, vorgesehen sein. Auch jedes andere hier verwendete Zählwort ist nicht dahingehend zu verstehen, dass eine Beschränkung auf genau die genannte Anzahl von Elementen gegeben ist. Vielmehr sind zahlenmäßige Abweichungen nach oben und nach unten möglich, soweit nichts Gegenteiliges angegeben ist.

Die für das Steuerungssystem beschriebenen Ausführungsformen und Merkmale gelten für das vorgeschlagene Verfahren entsprechend und umgekehrt.

Weitere mögliche Implementierungen der Erfindung umfassen auch nicht explizit genannte Kombinationen von zuvor oder im Folgenden bezüglich der Ausführungsbeispiele beschriebenen Merkmalen oder Ausführungsformen. Dabei wird der Fachmann auch Einzelaspekte als Verbesserungen oder Ergänzungen zu der jeweiligen Grundform der Erfindung hinzufügen.

Weitere vorteilhafte Ausgestaltungen und Aspekte der Erfindung sind Gegenstand der Unteransprüche sowie der im Folgenden beschriebenen Ausführungsbeispiele der Erfindung. Im Weiteren wird die Erfindung anhand von bevorzugten Ausführungsformen unter Bezugnahme auf die beigelegten Figuren näher erläutert.
Fig. 1 zeigt ein schematisches Blockdiagramm einer ersten Ausführungsform eines Steuerungssystems;
Fig. 2 zeigt ein schematisches Blockdiagramm einer weiteren Ausführungsform eines Steuerungssystems;
Fig. 3 zeigt eine schematische Ansicht einer ersten Ausführungsform eines optischen Systems, das als eine EUV-Lithographieanlage ausgebildet ist;
Fig. 4 zeigt eine schematische Ansicht einer zweiten Ausführungsform eines optischen Systems, das als eine DUV-Lithographieanlage ausgebildet ist;
Fig. 5 zeigt ein schematisches Blockschaltbild eines Ausführungsbeispiels eines Verfahrens zum Betreiben eines Steuerungssystems; und
Fig. 6 zeigt ein schematisches Blockdiagramm einer Ausführungsform einer Zustandsüberwachungseinheit.

In den Figuren sind gleiche oder funktionsgleiche Elemente mit denselben Bezugszeichen versehen worden, soweit nichts Gegenteiliges angegeben ist. Ferner sollte beachtet werden, dass die Darstellungen in den Figuren nicht notwendigerweise maßstabsgerecht sind.

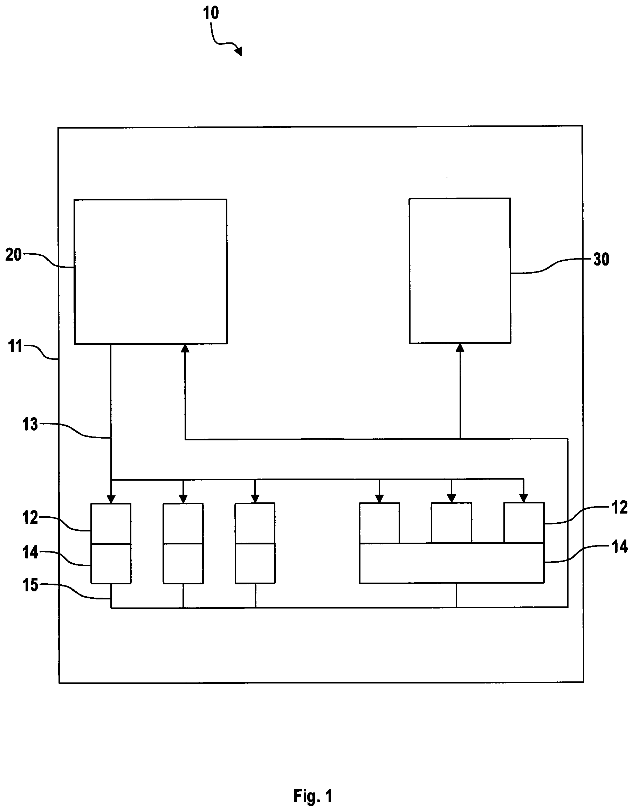

Fig. 1 zeigt ein schematisches Blockschaltbild eines ersten Ausführungsbeispiels eines Steuerungssystems 10. Das Steuerungssystem 10 ist beispielsweise als eine Automationsanlage, insbesondere eine Lithographieanlage, ausgebildet. Die Automationsanlage 10 umfasst mehrere Stellglieder 12, beispielsweise Werkzeuge, Werkzeugarme, Gelenke, Motoren und dergleichen mehr. In der Fig. 1 sind aus Gründen der Übersichtlichkeit nur sechs Stellglieder 12 gezeigt, von denen nur zwei mit Bezugszeichen versehen sind. Die Stellglieder 12 sind insbesondere durch eine Regelungseinheit 20, die als eine integrierte Schaltung, insbesondere ein SoC umfassend einen Mehrkernprozessor, Arbeitsspeicher, Flashspeicher sowie gegebenenfalls einen oder mehrere FPGA's sowie A/D-Wandler, ausgebildet ist, regelbar. Unter Regeln wird insbesondere verstanden, dass die Regelungseinheit 20 ein jeweiliges Stellglied 12 mittels eines Regelungssignals 13 ansteuert. Das Regelungssignal 13 kann beispielsweise ein Stromsignal oder auch ein Spannungssignal sein. Das Regelungssignal 13 bewirkt insbesondere, dass das Stellglied 12 eine aktuelle Stellung gemäß dem Regelungssignal 13 verändert, beispielsweise eine andere Position anfährt. Obwohl in der Fig. 1 das Regelungssignal 13 als eine Linie oder Leitung dargestellt ist, ist das Regelungssignal 13 für jedes Stellglied 12 individuell. Sofern eines der Stellglieder 12 mehrere regelbare Achsen oder Freiheitsgrade aufweist umfasst das Regelungssignal 13 für jede Achse oder für jeden Freiheitsgrad ein entsprechendes Regelungssignal 13. Je nach Stellglied 12 kann das Regelungssignal 13 auch als ein digitales Datensignal bereitgestellt werden.

In der Fig. 1 weisen die Stellglieder 12 zugeordnete Messglieder 14 auf. Ein jeweiliges Messglied 14 ist zum Erfassen von Stellgliedmessdaten 15 eingerichtet.

Stellgliedmessdaten 15 umfassen beispielsweise eine aktuelle Position des zugeordneten Stellglieds 12. Wie in der Fig. 1 rechterhand dargestellt, kann ein einzelnes Messglied 14 auch zum Erfassen von Stellgliedmessdaten 15 mehrerer Stellglieder 12 eingerichtet sein. Ein Messglied 14 kann beispielsweise als eine optische Messvorrichtung oder eine elektrische Messvorrichtung eingerichtet sein. Insbesondere optisch lässt sich ein Abstand und damit eine Position sehr genau, beispielsweise im Bereich von nm, bestimmen. Die Messglieder 14 können zum Ausgeben der Stellgliedmessdaten 15 als digitaler Datenstrom oder auch als analoges Spannungs- oder Stromsignal eingerichtet sein.

Die Stellgliedmessdaten 15 werden von dem jeweiligen Messglied 14 erfasst und ausgegeben, insbesondere an die Regelungseinheit 20, welche die Stellgliedmessdaten zur Regelung der Stellglieder 12 verwertet. Hierfür gleicht die Regelungseinheit 20 beispielsweise eine vorgegebene Soll-Position eines jeweiligen Stellglieds 12 mit der von den Stellgliedmessdaten 15 ableitbaren Ist-Position des Stellglieds 12 ab. Sofern Soll-Position und Ist-Position nicht übereinstimmen, gibt die Regelungseinheit 20 ein entsprechendes Regelungssignal 13 aus, woraufhin das damit geregelte Stellglied 12 seine Position anpasst.

Die Automationsanlage 10 weist zudem eine Zustandsüberwachungseinheit 30 auf. Die Zustandsüberwachungseinheit 30 ist insbesondere als eine integrierte Schaltung, insbesondere ein SoC umfassend einen Mehrkernprozessor, Arbeitsspeicher, Flashspeicher sowie gegebenenfalls einen oder mehrere FPGA's sowie A/D-Wandler, ausgebildet. Die Zustandsüberwachungseinheit kann abweichend von der Darstellung der Fig. 1 gemeinsam mit der Regelungseinheit 20 in einer integrierten Schaltung integriert sein. Die Zustandsüberwachungseinheit 30 ist dazu eingerichtet, die erfassten Stellgliedmessdaten 15 entgegenzunehmen und aus diesen einen Zustand der Automationsanlage 10 zu ermitteln. Ein Zustand der Automationsanlage 10 umfasst einen globalen Zustand, einen Gesamtzustand als auch einen Zustand einzelner Stellglieder 12. Der Zustand umfasst beispielsweise eine aktuelle Ist-Position eines jeden Stellglieds 12. Der Zustand umfasst vorzugsweise auch abgeleitete oder über eine gewisse Betriebsdauer kumulierte Größen, wie beispielsweise eine Anzahl von Ansteuerungen eines Stellglieds 12, einen Gesamtumfang von geleisteten Auslenkungen, wie eine zurückgelegte Wegstrecke, eines Stellglieds 12 und/oder auch eine bezüglich eines Bewegungsfreiheitsgrades kumulierte Aufenthaltsverteilung in einer bestimmten Position.

Beispielsweise weist die Zustandsüberwachungseinheit 30 einen Speicher auf (nicht dargestellt), der zum Speichern einer Anzahl früherer ermittelter Zustände, insbesondere die vor dem aktuell ermittelten Zustand, eingerichtet ist. Dann kann die Zustandsüberwachungseinheit 30 beispielsweise eine Veränderung des Zustands der Automationsanlage 10 erfassen. Vorteilhaft ist die Zustandsüberwachungseinheit 30 dazu eingerichtet, den Zustand der Automationsanlage 10 in Abhängigkeit des Regelungssignals 13 zu ermitteln. Insbesondere kann sie hierzu das Regelungssignal 13 für ein bestimmtes Stellglied 12 mit den erfassten Stellgliedmessdaten 15 des betreffenden Stellglieds 12 verknüpfen oder korrelieren. Aus derart verknüpften Daten lässt sich besonders einfach ermitteln, ob beispielsweise das Stellglied 12 auf das Regelungssignal 13 so reagiert, wie dies erwünscht und vorgesehen ist. Sollte dies nicht der Fall sein, so ist dies beispielsweise ein Hinweis darauf, dass das Stellglied 12 Verschleißerscheinungen aufweist und möglicherweise bald ausgetauscht werden muss.

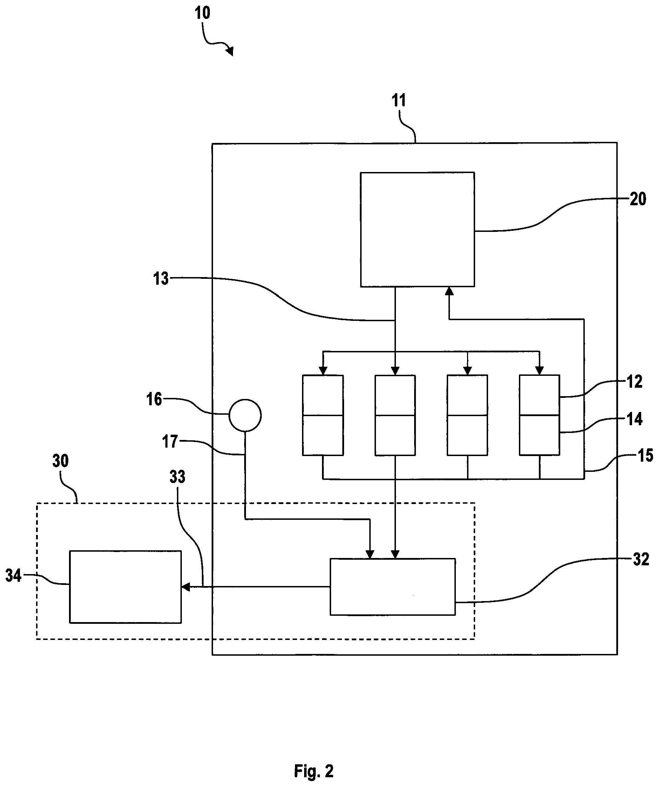

Fig. 2 zeigt ein schematisches Blockdiagramm einer weiteren Ausführungsform eines Steuerungssystems 10, das hier beispielsweise als ein optisches System, insbesondere ein Verifizierungs-Tool oder Test-Tool zum Überprüfen lithographisch hergestellter Strukturen. Das optische System 10 umfasst in diesem Ausführungsbeispiel einen Kernbereich, der als Embedded System 11 bezeichnet ist. Dieses Embedded System 11 zeichnet sich vorliegend dadurch aus, dass alle zugehörigen Komponenten, die nachfolgend aufgezählt werden, in einem Vakuum-Gehäuse (nicht dargestellt) angeordnet sind.

Aufgrund dieser Anordnung ergeben sich technische Randbedingungen an die Auslegung dieser Komponenten. Besonders problematisch ist eine Kühlung des Embedded System 11 oder dessen Komponenten, da Gas als Kühlmedium nicht vorhanden ist. Wärme, die beispielsweise von elektronischen Bauteilen erzeugt wird, muss daher entweder über eine Festkörper-Wärmebrücke und/oder über ein geschlossenes Flüssigkeits-Kühlsystem abgeführt werden, was technisch aufwendig ist, da ein Bauraum bei einem solchen optischen System 10 sehr begrenzt ist. Ferner erzeugen Flüssigkeitskühlungen Vibrationen, die sich auf das optische System übertragen können, was zu unerwünschten Auflösungsverlusten führen kann. Es ist daher vorteilhaft, so wenig Wärme wie möglich in dem Embedded System 11 zu erzeugen. Dies kann vor allem durch eine Reduktion einer Leistungsaufnahme elektronischer Komponenten erreicht werden. Daher ist beispielsweise eine zur Verfügung stehende Rechenkapazität in dem Embedded System nach oben beschränkt. Eine Erhöhung der Rechenkapazität kann vor allem durch eine Erhöhung der Effizienz, zum Beispiel die Rechenleistung pro Watt, der eingesetzten elektronischen Bauteile erreicht werden. Andererseits ist es wünschenswert, möglichst viele Betriebsdaten des Embedded System 11 zu erfassen und zu verarbeiten, beispielsweise zur Zustandsüberwachung.

Aufgrund der Vielzahl der in dem Embedded System 11 erfassten Rohdaten ergibt sich eine hohe Datenrate, die aufgrund der beschriebenen Beschränkungen nicht ohne weiteres aus dem Embedded System 11 heraus übertragen werden kann.

Das Embedded System 11 umfasst insbesondere eine Regelungseinheit 20 sowie eine Anzahl an Stellgliedern 12, von denen nur eines mit einem Bezugszeichen gekennzeichnet ist. Die Regelungseinheit 20 ist zum Erzeugen eines Regelungssignals 13 zum Regeln der Stellglieder 12 eingerichtet. Die Stellglieder 12 weisen ferner zugeordnete Messglieder 14 auf, die zum Erfassen von Stellgliedmessdaten 15 eingerichtet sind. Die Stellgliedmessdaten 15 dienen insbesondere zum Regeln der Stellglieder 12 durch die Regelungseinheit 20. Das Embedded System 11 weist ferner einen Umgebungssensor 16 auf, der zum Erfassen und Ausgeben von Umgebungssensordaten 17 eingerichtet ist. Der Umgebungssensor 16 ist beispielsweise als ein Temperatur- und Beschleunigungssensor ausgestaltet. Der Umgebungssensor 16 kann insbesondere eine Mehrzahl an Temperaturfühlern (nicht dargestellt) zum Erfassen einer lokalen Temperatur an mehreren Positionen innerhalb des Embedded System 11 aufweisen. Der Beschleunigungssensor ist vorzugsweise an einem Gehäuse (nicht dargestellt), das beispielsweise auch Force Frame genannt wird, angeordnet und erfasst dessen Vibrationen. Weitere Beschleunigungssensoren können beispielsweise an einer Aufhängung optischer Elemente (nicht dargestellt), insbesondere Spiegel- oder Linsenarrays, angeordnet sein und deren Vibrationen erfassen.

Zum Embedded System 11 gehört in diesem Beispiel weiterhin eine erste Verarbeitungseinheit 32. Die erste Verarbeitungseinheit 32 ist dazu eingerichtet, die erfassten Stellgliedmessdaten 15 entgegenzunehmen und diese gemäß einer Vorverarbeitungs-Routine zu verarbeiten. Das Ergebnis dieser Vorverarbeitung sind vorverarbeitete Zustandsdaten 33. Die erste Verarbeitungseinheit 32 nimmt ferner die von dem Umgebungssensor 16 erfassten Umgebungssensordaten 17 entgegen und berücksichtigt diese bei der Erzeugung der vorverarbeiteten Zustandsdaten 33. Die erzeugten vorverarbeiteten Zustandsdaten 33 überträgt die erste Verarbeitungseinheit 32 an eine zweite Verarbeitungseinheit 34, die außerhalb des Embedded System 11 angeordnet ist. Die erste Verarbeitungseinheit 32 und die zweite Verarbeitungseinheit 34 bilden gemeinsam eine Zustandsüberwachungseinheit 30.

Die erste Verarbeitungseinheit 32 ist insbesondere dazu eingerichtet, die erfassten Stellgliedmessdaten 15 derart zu verarbeiten, dass eine Datenrate der vorverarbeiteten Zustandsdaten 33 gegenüber einer Stellgliedmessdatenrate deutlich reduziert ist, beispielsweise noch 10% davon beträgt, und dennoch alle erfassten Daten berücksichtigt werden. Dies kann beispielsweise durch eine Mittelwertbildung (gleitender Mittelwert) erfolgen. Die Umgebungssensordaten 17 werden von der ersten Verarbeitungseinheit 32 dabei ebenfalls berücksichtigt. Insbesondere können die Umgebungssensordaten 17 auch als Rohdaten Teil der vorverarbeiteten Zustandsdaten 33 sein.

Die zweite Verarbeitungseinheit 34 außerhalb des Embedded System 11 weist gegenüber der ersten Verarbeitungseinheit 32 ein deutlich höhere Rechenleistung auf, weshalb diese beispielsweise mittels komplizierter Methoden aus den vorverarbeiteten Zustandsdaten 33 einen Zustand des optischen Systems 10 ermitteln kann. Vorzugsweise weist die zweite Verarbeitungseinheit 34 ferner eine zugeordnete Speichervorrichtung (nicht dargestellt) zum Speichern von Zustandsdaten auf.

Auf der Grundlage der ermittelten Zustände lässt sich insbesondere eine Prognose treffen, wann einzelne Elemente, insbesondere Stellglieder 12, des optischen Systems 10 verschleißbedingt ausfallen. Eine Reparatur oder eine Wartung des optischen System 10 kann daher frühzeitig geplant und somit besser in einen produktiven Betrieb des optischen System 10 eingebunden werden, weshalb unvorhergesehene Produktionsausfälle vermieden werden können.

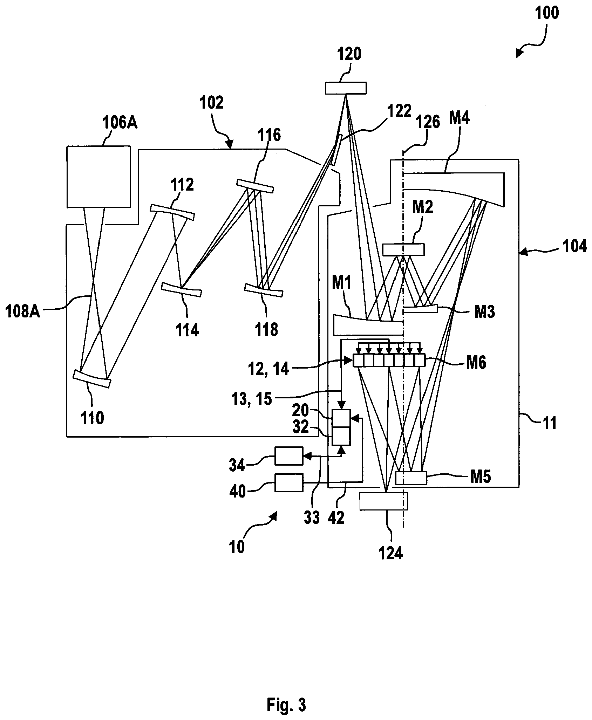

Fig. 3 zeigt eine schematische Ansicht eines optischen Systems 100, das hier als eine EUV-Lithographieanlage ausgebildet ist. Die EUV-Lithographieanlage 100 umfasst ein Strahlformungs- und Beleuchtungssystem 102 und ein Projektionssystem 104. Dabei steht EUV für "extremes Ultraviolett" (engl.: extreme ultra-violet, EUV) und bezeichnet eine Wellenlänge des Arbeitslichts zwischen 0,1 nm und 30 nm. Das Strahlformungs- und Beleuchtungssystem 102 und das Projektionssystem 104 sind jeweils in einem nicht gezeigten Vakuum-Gehäuse angeordnet, wobei jedes Vakuum-Gehäuse mit Hilfe einer nicht dargestellten Evakuierungsvorrichtung evakuiert wird. Die Vakuum-Gehäuse sind von einem nicht dargestellten Maschinenraum umgeben, in welchem Antriebsvorrichtungen zum mechanischen Verfahren beziehungsweise Einstellen von optischen Elementen vorgesehen sind. Ferner können auch elektrische Steuerungen und dergleichen in diesem Maschinenraum vorgesehen sein.

Die EUV-Lithographieanlage 100 weist eine EUV-Lichtquelle 106A auf. Als EUV-Lichtquelle 106A kann beispielsweise eine Plasmaquelle (oder ein Synchrotron) vorgesehen sein, welche Strahlung 108A im EUV-Bereich (extrem ultravioletter Bereich), also beispielsweise im Wellenlängenbereich von 5 nm bis 20 nm, aussendet. Im Strahlformungs- und Beleuchtungssystem 102 wird die EUV-Strahlung 108A gebündelt und die gewünschte Betriebswellenlänge aus der EUV-Strahlung 108A herausgefiltert. Die von der EUV-Lichtquelle 106A erzeugte EUV-Strahlung 108A weist eine relativ niedrige Transmissivität durch Luft auf, weshalb die Strahlführungsräume im Strahlformungs- und Beleuchtungssystem 102 und im Projektionssystem 104 evakuiert sind.

Das in Fig. 3 dargestellte Strahlformungs- und Beleuchtungssystem 102 weist fünf Spiegel 110, 112, 114, 116, 118 auf. Nach dem Durchgang durch das Strahlformungs- und Beleuchtungssystem 102 wird die EUV-Strahlung 108A auf eine Photomaske (engl.: reticle) 120 geleitet. Die Photomaske 120 ist ebenfalls als reflektives optisches Element ausgebildet und kann außerhalb der Systeme 102, 104 angeordnet sein. Weiter kann die EUV-Strahlung 108A mittels eines Spiegels 122 auf die Photomaske 120 gelenkt werden. Die Photomaske 120 weist eine Struktur auf, welche mittels des Projektionssystems 104 verkleinert auf einen Wafer 124 oder dergleichen abgebildet wird.

Das Projektionssystem 104 ist mit einer Regelungseinheit 20 und einer ersten Verarbeitungseinheit 32 in dem Vakuumgehäuse angeordnet und bildet mit diesen ein Embedded System 11. Das Projektionssystem 104 (auch als Projektionsobjektiv bezeichnet) weist fünf Spiegel M1 bis M5 und ein Mikrospiegelarray M6 zur Abbildung der Photomaske 120 auf den Wafer 124 auf. Dabei können einzelne Spiegel M1 bis M5 des Projektionssystems 104 symmetrisch zu einer optischen Achse 126 des Projektionssystems 104 angeordnet sein. Es sollte beachtet werden, dass die Anzahl der Spiegel M1 bis M5 der EUV-Lithographieanlage 100 nicht auf die dargestellte Anzahl beschränkt ist. Es können auch mehr oder weniger Spiegel M1 bis M5 vorgesehen sein. Des Weiteren sind die Spiegel M1 bis M5 in der Regel an ihrer Vorderseite zur Strahlformung gekrümmt. Das Mikrospiegelarray M6 umfasst beispielsweise 300 einzelne Mikrospiegel. Jeder Mikrospiegel weist zwei Freiheitsgrade auf, die durch Verkippen um zwei zueinander orthogonale Achsen gegeben sind und die individuell durch einen zugeordneten Aktuator einstellbar sind. Insofern stellt jeder Mikrospiegel ein Stellglied 12 mit zwei Freiheitsgraden dar. In der Fig. 3 sind aus Gründen der Übersicht nur sieben Mikrospiegel 12 dargestellt, von denen nur einer mit einem Bezugszeichen gekennzeichnet ist. Durch das Mikrospiegelarray M6 lässt sich ein Verlauf der EUV-Strahlung 108A anpassen, insbesondere können beispielsweise Wellenfrontvariationen ausgeglichen und damit eine verbesserte Auflösung der Photomaske 120 auf dem Wafer 124 erzielt werden.

Eine außerhalb des Projektionssystems 104 angeordnete Ansteuerungseinheit 40 ist zum Steuern der Mikrospiegel 12 eingerichtet, indem diese Stellgliedansteuerungsdaten 42 erzeugt, die an die Regelungseinheit 20 ausgegeben und übertragen werden. Die Stellgliedansteuerungsdaten 42 umfassen insbesondere eine Soll-Position für einen jeden der Mikrospiegel 12.

Die Mikrospiegel 12 werden von der Regelungseinheit 20 mittels eines Regelungssignals 13 geregelt. Das Regelungssignal 13 weist beispielsweise einen Takt von 10 kHz auf. Die den einzelnen Mikrospiegeln 12 zugeordneten Messglieder 14 weisen zum Beispiel einen Auslesetakt von 10 kHz auf, das heißt die Position eines jeweiligen Mikrospiegels 12 wird mit 10 kHz erfasst und als Stellgliedmessdaten 15 ausgegeben. Die Stellgliedmessdaten 15 weisen zum Beispiel einen Informationsgehalt von jeweils 32 Bit auf. Damit ergibt sich eine Datenrate der Stellgliedmessdaten 15 von beispielsweise 192 Mb/s oder 24 MB/s. Aufgrund der technischen Randbedingungen, wie beispielsweise anhand der Fig. 1 beschrieben, kann eine Datenverbindung zur Übertragung von Daten aus dem Embedded System 11 heraus oder in dieses hinein allerdings auf beispielsweise 4 MB/s beschränkt sein. Ferner kann ein Takt der Datenübertragung unterschiedlich zu einem Takt der der Messglieder 14, der Regelungseinheit 20 und/oder der ersten Verarbeitungseinheit 32 einer Zustandsüberwachungseinheit 30 (siehe z.B. Fig. 2) sein. Um die erfassten Stellgliedmessdaten 15 insgesamt für eine Zustandsüberwachung außerhalb des Embedded System 11 verwenden zu können, ist die Datenrate somit deutlich zu reduzieren. Dies wird durch eine Vorverarbeitung der Stellgliedmessdaten 15 durch die erste Verarbeitungseinheit 32 erreicht, die in Abhängigkeit der erfassten Stellgliedmessdaten 15 vorverarbeitete Zustandsdaten 33 erzeugt. Da insbesondere Steuerdaten von einer außenliegenden Steuerung (nicht dargestellt) zur Regelung der Mikrospiegel 12 und gegebenenfalls weiterer regelbarer Elemente in das Embedded System 11 zu übertagen sind, steht nicht die gesamte Bandbreite zu Übertragung der vorverarbeiteten Zustandsdaten 33 zur Verfügung.

Die erste Verarbeitungseinheit 32 ist daher dazu eingerichtet, die mit einer Datenrate von 24 MB/s erfassten Stellgliedmessdaten 15 zu empfangen und vorverarbeitete Zustandsdaten 33 mit einer Datenrate von höchstens 2,4 MB/s zu erzeugen. Da die Zustandsüberwachung wie hier beschrieben relativ unkritisch ist, kann diese zeitlich nachrangig erfolgen, so dass beispielsweise zeitkritische Steuerungsdaten, insbesondere die Stellgliedansteuerungsdaten 42, bevorzugt übertragen und/oder berechnet werden. Die vorverarbeiteten Zustandsdaten 33 lassen sich dazu beispielsweise kurzfristig zwischenspeichern, um zu einem Zeitpunkt, da eine größere Bandbreite zur Datenübertragung zur Verfügung steht, übertragen zu werden.

Die zweite Verarbeitungseinheit 34 empfängt die vorverarbeiteten Zustandsdaten 33 und ermittelt in Abhängigkeit von diesen einen Zustand der EUV-Lithographieanlage 100, insbesondere der Mikrospiegel 12 des Mikrospiegelarrays M6. Indem die erfassten Stellgliedmessdaten 15 als Grundlage für die Zustandsüberwachung genutzt werden, lassen sich zusätzliche Umgebungssensoren 16 (siehe z.B. Fig. 2) einsparen. Alternativ lässt sich der Zustand der EUV-Lithographieanlage 100 in Verbindung mit Umgebungssensoren 16 auf diese Weise deutlich genauer überwachen.

In diesem Ausführungsbeispiel bilden das Mikrospiegelarray M6 mit den Mikrospiegeln 12 und zugeordneten Messgliedern 14, die Regelungseinheit 20, die erste Verarbeitungseinheit 32, die zweite Verarbeitungseinheit 34 und die Ansteuerungseinheit 40 ein Steuerungssystem 10.

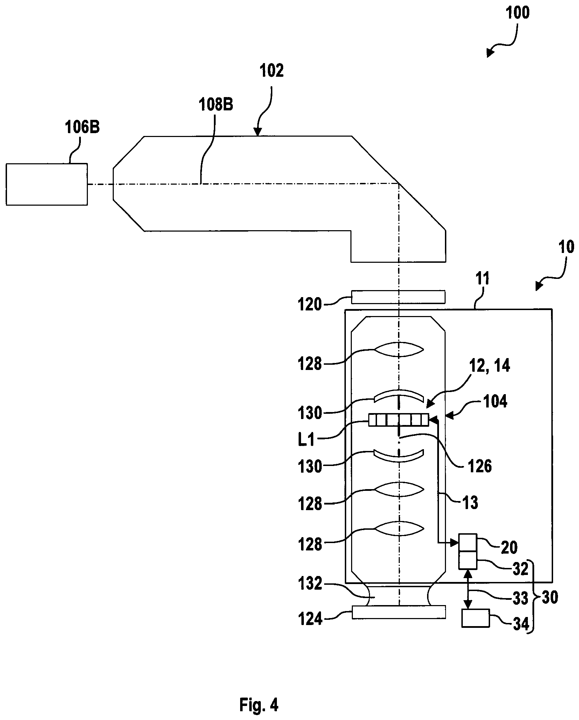

Fig. 4 zeigt eine schematische Ansicht einer zweiten Ausführungsform eines optischen Systems 100, das als eine DUV-Lithographieanlage ausgebildet ist. Die DUV-Lithographieanlage 100 umfasst ein Strahlformungs- und Beleuchtungssystem 102 und ein Projektionssystem 104. Dabei steht DUV für "tiefes Ultraviolett" (engl.: deep ultra-violet, DUV) und bezeichnet eine Wellenlänge des Arbeitslichts zwischen 30 nm und 250 nm. Das Strahlformungs- und Beleuchtungssystem 102 und das Projektionssystem 104 können - wie bereits mit Bezug zu Fig. 3 beschrieben - in einem Vakuumgehäuse angeordnet und/oder von einem Maschinenraum mit entsprechenden Antriebsvorrichtungen umgeben sein.

Die DUV-Lithographieanlage 100B weist eine DUV-Lichtquelle 106B auf. Als DUV-Lichtquelle 106B kann beispielsweise ein ArF-Excimerlaser vorgesehen sein, welcher Strahlung 108B im DUV-Bereich bei beispielsweise 193 nm emittiert.

Das in Fig. 4 dargestellte Strahlformungs- und Beleuchtungssystem 102 leitet die DUV-Strahlung 108B auf eine Photomaske 120. Die Photomaske 120 ist als transmissives optisches Element ausgebildet und kann außerhalb der Systeme 102, 104 angeordnet sein. Die Photomaske 120 weist eine Struktur auf, welche mittels des Projektionssystems 104 verkleinert auf einen Wafer 124 oder dergleichen abgebildet wird.

Das Projektionssystem 104 weist mehrere Linsen 128 und/oder Spiegel 130 zur Abbildung der Photomaske 120 auf den Wafer 124 auf. Dabei können einzelne Linsen 128 und/oder Spiegel 130 des Projektionssystems 104 symmetrisch zu einer optischen Achse 126 des Projektionssystems 104 angeordnet sein. Es sollte beachtet werden, dass die Anzahl der Linsen 128 und Spiegel 130 der DUV-Lithographieanlage 100 nicht auf die dargestellte Anzahl beschränkt ist. Es können auch mehr oder weniger Linsen 128 und/oder Spiegel 130 vorgesehen sein. Des Weiteren sind die Spiegel 130 in der Regel an ihrer Vorderseite zur Strahlformung gekrümmt.

Ein Luftspalt zwischen der letzten Linse 128 und dem Wafer 124 kann durch ein flüssiges Medium 132 ersetzt sein, welches einen Brechungsindex > 1 aufweist. Das flüssige Medium 132 kann beispielsweise hochreines Wasser sein. Ein solcher Aufbau wird auch als Immersionslithographie bezeichnet und weist eine erhöhte photolithographische Auflösung auf. Das Medium 132 kann auch als Immersionsflüssigkeit bezeichnet werden.

Das Projektionssystem 104 ist mit einer Regelungseinheit 20 und einer ersten Verarbeitungseinheit 32 in einem Vakuumgehäuse angeordnet und bildet mit diesen ein Embedded System 11. Das Projektionssystem 104 weist insbesondere ein Mikrolinsenarray L1 auf, welches eine Vielzahl aktuierbarer Mikrolinsen 12 aufweist, und bildet gemeinsam mit der Ansteuerlogik 20, 32, 34 ein Steuerungssystem 10. Eine Position von jeder Mikrolinse 12 des Mikrolinsenarrays L1 wird durch ein zugeordnetes Messglied 14 erfasst und an die Regelungseinheit 20 in Form von Stellgliedmessdaten 15 ausgegeben, welche in Abhängigkeit dieser ein Regelungssignal 13 zur Regelung der Mikrolinsen 12 erzeugt und ausgibt.

Die erste Verarbeitungseinheit 32 ist mit vorliegend mit der Regelungseinheit 20 auf einem Board angeordnet, insbesondere kann vorgesehen sein, dass die Regelungseinheit 20 und die erste Verarbeitungseinheit 32 sich bestimmte Ressourcen teilen. Die erste Verarbeitungseinheit 32 erzeugt in Abhängigkeit der erfasste Stellgliedmessdaten 15 und des Regelungssignals 13 vorverarbeitete Messdaten 33, die an eine außerhalb des Vakuum-Gehäuses liegende zweite Verarbeitungseinheit 34 übertragen werden. Indem die erste Verarbeitungseinheit 32 das Regelungssignal 13 berücksichtigt, können beispielsweise Verschleißerscheinungen erfasst werden und eine Datenrate der vorverarbeiteten Zustandsdaten geringgehalten werden. Beispielsweise kann eine Abhängigkeit einer Position einer Mikrolinse 12 von einem Strom, mit dem der Aktuator der Mikrolinse 12 angesteuert wird, durch die erste Verarbeitungseinheit 32 kontinuierlich ermittelt oder überwacht werden. Sofern die ermittelte Abhängigkeit einer bestimmten vorgegebenen Abhängigkeit entspricht, ist mit dem Aktuator alles in Ordnung. Es kann vorgesehen sein, dass in diesem Fall keine vorverarbeiteten Zustandsdaten 33 erzeugt werden. Sofern eine Abweichung von der vorgegebenen Abhängigkeit und/oder eine zeitliche Veränderung der Abhängigkeit ermittelt wird, kann vorgesehen sein, entsprechende vorverarbeitete Zustandsdaten zu erzeugen und auszugeben. Bei einem solchen Vorgehen ist somit implizit ermittelt, dass ein Zustand des optischen Systems 100 oder des Steuerungssystems 10 gut oder in Ordnung ist, wenn keine vorverarbeiteten Zustandsdaten 33 erzeugt und ausgegeben werden.

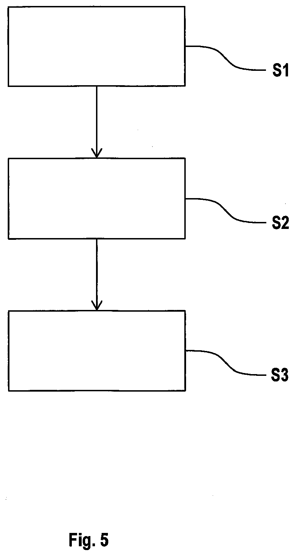

Fig. 5 zeigt ein schematisches Blockschaltbild eines Verfahrens zum Betreiben eines Steuerungssystems 10, beispielsweise der Fig. 1 oder 2 oder auch eines optischen Systems 100, wie in den Fig. 3 oder 4 dargestellt.

In einem ersten Verfahrensschritt S1 werden durch die den Stellgliedern 12 zugeordneten Messgliedern 14 Stellgliedmessdaten 15 erfasst. Die Stellgliedmessdaten 15 umfassen insbesondere Positionssensordaten, die eine Position des jeweiligen Stellglieds 12 charakterisieren. Die erfassten Stellgliedmessdaten 15 werden insbesondere eine Regelungseinheit 20 und eine Zustandsüberwachungseinheit 30 ausgegeben oder übertragen.

In einem zweiten Verfahrensschritt S2 erzeugt die Regelungseinheit 20 ein Regelungssignal 13 zum Regeln der Stellglieder 12 in Abhängigkeit der Stellgliedmessdaten 15. Damit wird beispielsweise sichergestellt, dass sich die jeweiligen Stellglieder 12 in einer erwünschten Soll-Position befinden. Je nach Genauigkeit und Geschwindigkeit der Regelung lassen sich damit auch externe Umwelteinflüsse, wie beispielsweise Schwingungen, Erschütterungen und/oder Luftunruhe ausgleichen. Bei optischen Systemen spricht man auch von adaptiver Optik.

In einem dritten Verfahrensschritt S3 überwacht die Zustandsüberwachungseinheit 30 einen Zustand des Steuerungssystems 10 in Abhängigkeit der erfassten Stellgliedmessdaten 15. Zum Beispiel ermittelt die Zustandsüberwachungseinheit 30 die von einem Stellglied 12 im Laufe einer Betriebsdauer des Steuerungssystems 10 zurückgelegte Gesamtstrecke. Aus einer solchen Information lässt insbesondere abschätzen, wie hoch eine verbleibende Lebenserwartung des Stellglieds 12 ist, und daher eine Wartung des Steuerungssystems 10 besser planen.

Das Verfahren kann neben den dargestellten Verfahrensschritten viele weitere Schritte umfassen, die sich beispielsweise aus der Beschreibung des Steuerungssystem 10 der Fig. 1 oder 2 sowie aus der Beschreibung des optischen Systems der Fig. 3 oder 4 ergeben. Insofern sind die dort beschriebenen Aspekte als Teilschritte der hier beschriebenen Verfahrensschritte und/oder zusätzliche Schritte des Verfahrens zu betrachten.

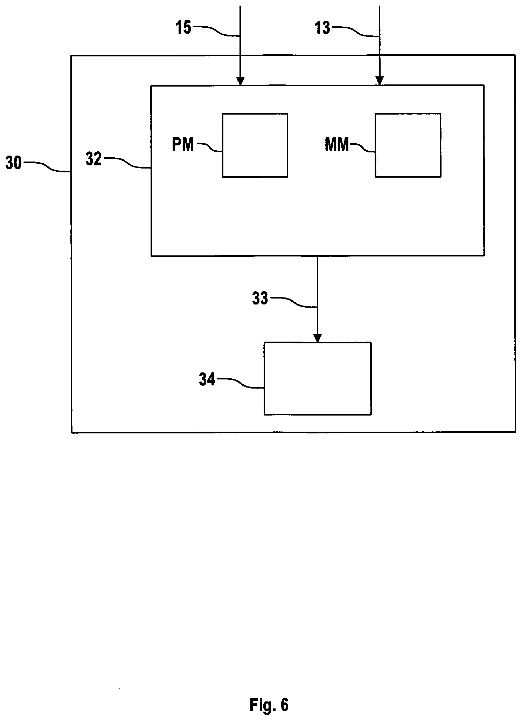

Fig. 6 zeigt ein schematisches Blockdiagramm einer Ausführungsform einer Zustandsüberwachungseinheit 30. Die Zustandsüberwachungseinheit 30 kann beispielsweise in dem Steuerungssystem 10 der Fig. 1 oder 2 oder als Teil des Steuerungssystem 10 des optischen Systems 100 der Fig. 3 oder 4 verwendet werden. Die dargestellte Zustandsüberwachungseinheit 30 umfasst eine erste Verarbeitungseinheit 32 und eine zweite Verarbeitungseinheit 34. Vorzugsweise ist die erste Verarbeitungseinheit 32 in dem Embedded System 11 (siehe Fig. 2, 3 oder 4) angeordnet, und die zweite Verarbeitungseinheit 34 ist außerhalb des Embedded System 11 angeordnet. Wie anhand der Fig. 1 - 4 beschrieben, empfängt die Zustandsverarbeitungseinheit 30 Stellgliedmessdaten 15 von zumindest einem Messglied 14 (siehe Fig. 1 - 4), das einem Stellglied 12 (siehe Fig. 1 - 4) des Steuerungssystems 10 zugeordnet ist. Optional kann die Zustandsverarbeitungseinheit 30 zusätzlich hierzu das von einer Regelungseinheit 20 (siehe Fig. 1 - 4) erzeugte Regelungssignal 13 empfangen.

In diesem Beispiel ist die erste Verarbeitungseinheit 32 insbesondere dazu eingerichtet, vorverarbeitete Zustandsdaten 33 in Abhängigkeit der erfassten Stellgliedmessdaten 15 und eines physikalischen Modells PM und/oder mathematischen Modells MM des jeweiligen Stellglieds 12 zu erzeugen. Optional kann zusätzlich das Regelungssignal 13 bei dem Erzeugen der vorverarbeiteten Zustandsdaten 33 berücksichtigt werden. Ein physikalisches Modell PM umfasst beispielsweise eine mathematische Beschreibung physikalischer Zusammenhänge und/oder physikalische Parameter. Ein Beispiel für ein solches physikalisches Modell PM für ein Stellglied, das beispielsweise als ein magnetischer Aktuator ausgebildet ist, ist eine Relation zwischen einem Spulenstrom und einem hierdurch erzeugten Magnetfeld sowie eine durch das erzeugte Magnetfeld bewirkte Lageänderung des Aktuators, wobei beispielsweise auch thermische Effekte berücksichtigt werden. Ein Beispiel für ein mathematisches Modell MM ist das Bilden eines Mittelwerts, wobei es sich insbesondere um ein gewichtetes Mittel und/oder ein gleitendes Mittel handeln kann. Für unterschiedliche Stellglieder 12 können, in Abhängigkeit der Art jeweiligen Stellglieds 12, unterschiedliche physikalische Modelle PM und/oder mathematische Modell MM zur Anwendung kommen.

Derartige physikalische Modelle PM und/oder mathematische Modelle MM erlauben es vorteilhaft, aus einer großen Datenmenge einen oder mehrere charakteristische Werte für ein jeweiliges System zu ermitteln oder abzuleiten, die insbesondere eine physikalische Dimension oder Bedeutung aufweisen können. Weiterhin kann das physikalische Modell PM und/oder das mathematische Modell MM statistische Methoden umfassen, so dass beispielsweise ausgehend von Werteverteilungen Momente dieser Verteilungen ermittelt werden können, beispielsweise eine Standardabweichung, eine Varianz und dergleichen mehr.

Obwohl die vorliegende Erfindung anhand von Ausführungsbeispielen beschrieben wurde, ist sie vielfältig modifizierbar. Insbesondere kann das beschriebene Konzept der Zustandsüberwachung auf eine Vielzahl von Steuerungssystemen angewendet werden. Der besondere Vorteil ist es, dass die von den Messgliedern erfassten Daten direkt, insbesondere vollständig, zur Zustandsüberwachung verwendet werden, wohingegen diese Daten bei herkömmlichen Steuerungssystemen nur zur Regelung verwendet werden. Diese herkömmlichen Systeme benötigen zur Zustandsüberwachung daher Umgebungssensoren. Damit kann der Zustand des erfindungsgemäßen Steuerungssystems deutlich präziser und auch ohne Verwendung von Umgebungssensoren überwacht werden.

### BEZUGSZEICHENLISTE

- 10: Steuerungssystem
- 11: Embedded System
- 12: Stellglied
- 13: Regelungssignal
- 14: Messglied
- 15: Stellgliedmessdaten
- 16: Umgebungssensor
- 17: Umgebungssensordaten
- 20: Regelungseinheit
- 30: Zustandsüberwachungseinheit
- 32: erste Verarbeitungseinheit
- 33: vorverarbeitete Zustandsdaten
- 34: zweite Verarbeitungseinheit
- 40: Ansteuerungseinheit
- 42: Stellgliedansteuerungsdaten
- 100: optisches System
- 102: Strahlformungs- und Beleuchtungssystem
- 104: Projektionssystem
- 106A: EUV-Lichtquelle
- 106B: DUV-Lichtquelle
- 108A: EUV-Strahlung
- 108B: DUV-Strahlung
- 110: Spiegel
- 112: Spiegel
- 114: Spiegel
- 116: Spiegel
- 118: Spiegel
- 120: Photomaske
- 122: Spiegel
- 124: Wafer
- 126: optische Achse
- 128: Linse
- 130: Spiegel
- 132: Medium

- L1: Mikrolinsenarray
- M1: Spiegel
- M2: Spiegel
- M3: Spiegel
- M4: Spiegel
- M5: Spiegel
- M6: Mikrospiegelarray
- MM: mathematisches Modell
- PM: physikalisches Modell
- S 1: Verfahrensschritt
- S2: Verfahrensschritt
- S3: Verfahrensschritt

## Patentansprüche

1. Steuerungssystem (10), insbesondere für ein optisches System (100), aufweisend:
ein Stellglied (12),
ein Messglied (14) zum Erfassen von Stellgliedmessdaten (15) des Stellglieds (12),
eine Regelungseinheit (20) zum Erzeugen eines Regelungssignals (13) zum Regeln des Stellglieds (12) in Abhängigkeit der erfassten Stellgliedmessdaten (15), und
eine Zustandsüberwachungseinheit (30) zum Überwachen eines Zustands des Steuerungssystems (10) in Abhängigkeit der erfassten Stellgliedmessdaten (15), **dadurch gekennzeichnet, dass** die Zustandsüberwachungseinheit (30) umfasst:
eine erste Verarbeitungseinheit (32) zum Erzeugen von vorverarbeiteten Zustandsdaten (33) in Abhängigkeit
(i) der erfassten Stellgliedmessdaten (15) und eines physikalischen Modells (PM) und/oder eines mathematischen Modells (MM) des Stellglieds (12) oder
(ii) der erfassten Stellgliedmessdaten (15), eines physikalischen Modells (PM) und/oder eines mathematischen Modells (MM) des Stellglieds (12) und des erzeugten Regelungssignals (13), und
eine zweite Verarbeitungseinheit (34) zum Ermitteln des Zustands des Steuerungssystems (10) in Abhängigkeit der vorverarbeiteten Zustandsdaten (33).

2. Steuerungssystem gemäß Anspruch 1, **dadurch gekennzeichnet, dass** die erste Verarbeitungseinheit (32) dazu eingerichtet ist, die erfassten Stellgliedmessdaten (15) kontinuierlich, insbesondere synchron zur Erfassung der Stellgliedmessdaten (15) durch das Messglied (14), zu erfassen und zu verarbeiten.

3. Steuerungssystem gemäß Anspruch 1 oder 2, **dadurch gekennzeichnet, dass** die erste Verarbeitungseinheit (32) dazu eingerichtet ist, die vorverarbeiteten Zustandsdaten (15) in Abhängigkeit der erfassten Stellgliedmessdaten (15) im laufenden Betrieb des Steuerungssystems (10) zu erzeugen.

4. Steuerungssystem gemäß einem der Ansprüche 1 bis 3, ferner aufweisend
eine Ansteuerungseinheit (40) zum Erzeugen von Stellgliedansteuerungsdaten (42) in Abhängigkeit eines durchgeführten Betriebsprogramms,
wobei die Regelungseinheit (20) zum Erzeugen des Regelungssignals (13) in Abhängigkeit der Stellgliedansteuerungsdaten (42) eingerichtet ist, und
wobei die erste Verarbeitungseinheit (32) zum Erzeugen der vorverarbeiteten Zustandsdaten (33) in Abhängigkeit des aktuell durchgeführten Betriebsprogramms eingerichtet ist.

5. Steuerungssystem gemäß einem der Ansprüche 1 bis 4, ferner aufweisend einen Umgebungssensor (16) zum Erfassen von Umgebungssensordaten (17) aufweist,
wobei die erste Verarbeitungseinheit (32) zum Erzeugen der vorverarbeiteten Zustandsdaten (33) in Abhängigkeit der erfassten Umgebungssensordaten (17) eingerichtet ist.

6. Steuerungssystem gemäß einem der Ansprüche 1 bis 5, wobei das Messglied (14) dazu eingerichtet ist, die Stellgliedmessdaten (15) mit einer Frequenz von 1 kHz bis 10 kHz, bevorzugt bis 100 kHz, weiter bevorzugt bis 1 MHz zu erfassen.

7. Steuerungssystem gemäß einem der Ansprüche 1 bis 6, wobei die Regelungseinheit (20) dazu eingerichtet ist, das Regelungssignal (13) mit einer Frequenz von 1 kHz bis 10 kHz, bevorzugt bis 100 kHz, weiter bevorzugt bis 1 MHz zu erzeugen.

8. Steuerungssystem gemäß einem der Ansprüche 1 bis 7, wobei die erste Verarbeitungseinheit (32) dazu eingerichtet ist, die vorverarbeiteten Zustandsdaten (15) mit einer Datenrate zu erzeugen, die höchstens 10%, bevorzugt höchstens 1% einer Datenrate der erfassten Stellgliedmessdaten (15) beträgt, wobei jedes einzelne erfasste Stellgliedmessdatum in die vorverarbeiteten Zustandsdaten (33) eingeht.

9. Steuerungssystem nach einem der Ansprüche 1 bis 8, wobei das Stellglied (12) einen Aktuator zum Einstellen einer Position eines Elements umfasst, insbesondere einen Lorentzaktuator, und das Messglied (14) einen Positionssensor zum Erfassen der Position des Elements, insbesondere ein Interferometer und/oder CCD-Kamera, umfasst.

10. Steuerungssystem nach einem der Ansprüche 1 bis 9, wobei die Zustandsüberwachungseinheit (30) dazu eingerichtet ist, in Abhängigkeit des überwachten Zustands oder der vorverarbeiteten Zustandsdaten (33) einen zukünftigen Zustand des Steuerungssystems (10), insbesondere einen Fehlerzustand oder einen eine Wartung erforderlich machenden Zustand eines optischen Systems, zu ermitteln.

11. Optisches System (100), insbesondere Lithographieanlage, mit einem Steuerungssystem (10) nach einem der Ansprüche 1 bis 10.

12. Verfahren zum Betreiben eines Steuerungssystems (10), insbesondere nach einem der Ansprüche 1 bis 10, oder eines optischen Systems (100), insbesondere nach Anspruch 11, mit den Schritten:
a) Erfassen von Stellgliedmessdaten (15) eines Stellglieds (12),
b) Erzeugen eines Regelungssignals (13) in Abhängigkeit der erfassten Stellgliedmessdaten (15), und
c) Überwachen eines Zustands des Steuerungssystems (10) oder des optischen Systems (100) in Abhängigkeit der Stellgliedmessdaten (15), **dadurch gekennzeichnet, dass** vorverarbeitete Zustandsdaten in Abhängigkeit
(i) der erfassten Stellgliedmessdaten (15) und eines physikalischen Modells (PM) und/oder eines mathematischen Modells (MM) des Stellglieds (12) oder
(ii) der erfassten Stellgliedmessdaten (15), eines physikalischen Modells (PM) und/oder eines mathematischen Modells (MM) des Stellglieds (12) und des erzeugten Regelungssignals (13)
erzeugt werden und der Zustand des Steuerungssystems (10) oder des optischen Systems (100) in Abhängigkeit der vorverarbeiteten Zustandsdaten (33) ermittelt wird.

13. Verfahren nach Anspruch 12, wobei das optische System (100) in Abhängigkeit des überwachten Zustands gewartet wird.

## Claims

1. Control system (10), in particular for an optical system (100), comprising:
an actuating element (12),
a measuring element (14) for acquiring actuating element measurement data (15) of the actuating element (12),
a regulating unit (20) for generating a regulating signal (13) for regulating the actuating element (12) depending on the acquired actuating element measurement data (15), and
a state monitoring unit (30) for monitoring a state of the control system (10) depending on the acquired actuating element measurement data (15), **characterized in that** the state monitoring unit (30) comprises:
a first processing unit (32) for generating preprocessed state data (33) depending on
(i) the acquired actuating element measurement data (15) and a physical model (PM) and/or a mathematical model (MM) of the actuating element (12) or
(ii) the acquired actuating element measurement data (15), a physical model (PM) and/or a mathematical model (MM) of the actuating element (12) and the generated regulating signal (13), and
a second processing unit (34) for determining the state of the control system (10) depending on the preprocessed state data (33).

2. Control system according to Claim 1, **characterized in that** the first processing unit (32) is configured to acquire and to process the acquired actuating element measurement data (15) continuously, in particular synchronously with the acquisition of the actuating element measurement data (15) by the measuring element (14).

3. Control system according to Claim 1 or 2, **characterized in that** the first processing unit (32) is configured to generate the preprocessed state data (15) depending on the acquired actuating element measurement data (15) during ongoing operation of the control system (10).

4. Control system according to any of Claims 1 to 3, furthermore comprising a driving unit (40) for generating actuating element driving data (42) depending on an implemented operating program,
wherein the regulating unit (20) is configured for generating the regulating signal (13) depending on the actuating element driving data (42), and
wherein the first processing unit (32) is configured for generating the preprocessed state data (33) depending on the currently implemented operating program.

5. Control system according to any of Claims 1 to 4, furthermore comprising a surroundings sensor (16) for acquiring surroundings sensor data (17),
wherein the first processing unit (32) is configured for generating the preprocessed state data (33) depending on the acquired surroundings sensor data (17).

6. Control system according to any of Claims 1 to 5, wherein the measuring element (14) is configured to acquire the actuating element measurement data (15) with a frequency of 1 kHz to 10 kHz, preferably to 100 kHz, more preferably to 1 MHz.

7. Control system according to any of Claims 1 to 6, wherein the regulating unit (20) is configured to generate the regulating signal (13) with a frequency of 1 kHz to 10 kHz, preferably to 100 kHz, more preferably to 1 MHz.

8. Control system according to any of Claims 1 to 7, wherein the first processing unit (32) is configured to generate the preprocessed state data (15) with a data rate that is at most 10%, preferably at most 1%, of a data rate of the acquired actuating element measurement data (15), wherein each individual acquired actuating element measurement datum influences the preprocessed state data (33).

9. Control system according to any of Claims 1 to 8, wherein the actuating element (12) comprises an actuator for setting a position of an element, in particular a Lorentz actuator, and the measuring element (14) comprises a position sensor for acquiring the position of the element, in particular an interferometer and/or CCD camera.

10. Control system according to any of Claims 1 to 9, wherein the state monitoring unit (30) is configured to determine a future state of the control system (10), in particular a fault state or a maintenance-necessitating state of an optical system, depending on the monitored state or the preprocessed state data (33).

11. Optical system (100), in particular a lithography apparatus, comprising a control system (10) according to any one of Claims 1 to 10.

12. Method for operating a control system (10), in particular according to any of Claims 1 to 10, or an optical system (100), in particular according to Claim 11, comprising the following steps:
a) Acquiring actuating element measurement data (15) of an actuating element (12),
b) Generating a regulating signal (13) depending on the acquired actuating element measurement data (15), and
c) Monitoring a state of the control system (10) or of the optical system (100) depending on the actuating element measurement data (15), **characterized in that** preprocessed state data are generated depending on
(i) the acquired actuating element measurement data (15) and a physical model (PM) and/or a mathematical model (MM) of the actuating element (12) or
(ii) the acquired actuating element measurement data (15), a physical model (PM) and/or a mathematical model (MM) of the actuating element (12) and the generated regulating signal (13),
and the state of the control system (10) or of the optical system (100) is determined depending on the preprocessed state data (33).

13. Method according to Claim 12, wherein the optical system (100) is maintained depending on the monitored state.

## Revendications

1. Système de commande (10), destiné en particulier à un système optique (100), ledit système de commande comportant
un élément d'actionnement (12),
un élément de mesure (14) destiné à acquérir des données de mesure (15) de l'élément d'actionnement (12),
une unité de régulation (20) destinée à générer un signal de régulation (13) destiné à réguler l'élément d'actionnement (12) en fonction des données de mesure acquises (15) de l'élément d'actionnement, et
une unité de surveillance d'état (30) destinée à surveiller un état du système de commande (10) en fonction des données de mesure acquises (15) de l'élément d'actionnement, **caractérisé en ce que** l'unité de surveillance d'état (30) comprend :
une première unité de traitement (32) destinée à générer des données d'état prétraitées (33) en fonction
(i) des données de mesure acquises (15) de l'élément d'actionnement et d'un modèle physique (PM) et/ou d'un modèle mathématique (MM) de l'élément d'actionnement (12) ou
(ii) des données de mesure acquises (15) de l'élément d'actionnement, d'un modèle physique (PM) et/ou d'un modèle mathématique (MM) de l'élément d'actionnement (12) et du signal de régulation généré (13), et
une deuxième unité de traitement (34) destinée à déterminer l'état du système de commande (10) en fonction des données d'état prétraitées (33).

2. Système de commande selon la revendication 1, **caractérisé en ce que** la première unité de traitement (32) est conçue pour acquérir et traiter les données de mesure acquises (15) de l'élément d'actionnement de façon continue, notamment de manière synchrone avec l'acquisition des données de mesure (15) de l'élément d'actionnement par l'élément de mesure (14).

3. Système de commande selon la revendication 1 ou 2, **caractérisé en ce que** la première unité de traitement (32) est conçue pour générer les données d'état prétraitées (15) en fonction des données de mesure acquises (15) de l'élément d'actionnement au cours du fonctionnement du système commande (10).

4. Système de commande selon l'une des revendications 1 à 3, comportant en outre
une unité de commande (40) destinée à générer des données de commande (42) de l'élément d'actionnement en fonction d'un programme de fonctionnement exécuté, l'unité de régulation (20) étant conçue pour générer le signal de régulation (13) en fonction des données de commande (42) de l'élément d'actionnement, et
la première unité de traitement (32) étant conçue pour générer les données d'état prétraitées (33) en fonction du programme de fonctionnement actuellement exécuté.

5. Système de commande selon l'une des revendications 1 à 4, comportant en outre
un capteur d'environnement (16) destiné à acquérir des données de capteur d'environnement (17),
la première unité de traitement (32) étant conçue pour générer les données d'état prétraitées (33) en fonction des données de capteur d'environnement acquises (17).

6. Système de commande selon l'une des revendications 1 à 5, l'élément de mesure (14) étant conçu pour acquérir les données de mesure (15) de l'élément d'actionnement à une fréquence de 1 kHz à 10 kHz, de préférence jusqu'à 100 kHz, plus préférablement jusqu'à 1 MHz.

7. Système de commande selon l'une des revendications 1 à 6, l'unité de régulation (20) étant conçue pour générer le signal de régulation (13) à une fréquence de 1 kHz à 10 kHz, de préférence jusqu'à 100 kHz, plus préférablement jusqu'à 1 MHz.

8. Système de commande selon l'une des revendications 1 à 7, la première unité de traitement (32) étant conçue pour générer les données d'état prétraitées (15) à un débit de données qui est égal au plus à 10 %, de préférence au plus à 1 %, d'un débit de données des données de mesure acquises (15) de l'élément d'actionnement, chaque donnée de mesure acquise individuelle de l'élément d'actionnement étant incluse dans les données d'état prétraitées (33).

9. Système de commande selon l'une des revendications 1 à 8, l'élément d'actionnement (12) comprenant un actionneur destiné à régler une position d'un élément, en particulier d'un actionneur de Lorentz, et l'élément de mesure (14) comprenant un capteur de position destiné à acquérir la position de l'élément, en particulier d'un interféromètre et/ou d'une Caméra CCD.

10. Système de commande selon l'une des revendications 1 à 9, l'unité de surveillance d'état (30) étant conçue pour déterminer un état futur du système de commande (10), en particulier un état d'erreur ou un état d'un système optique nécessitant une maintenance, en fonction de l'état surveillé ou des données d'état prétraitées (33).

11. Système optique (100), notamment système de lithographie, comprenant un système de commande (10) selon l'une des revendications 1 à 10.

12. Procédé de fonctionnement d'un système de commande (10), notamment selon l'une des revendications 1 à 10, ou d'un système optique (100), notamment selon la revendication 11, ledit procédé comprenant les étapes suivantes
a) acquérir des données de mesure (15) d'un élément d'actionnement (12),
b) générer un signal de régulation (13) en fonction des données de mesure acquises (15) de l'élément d'actionnement, et
c) surveiller un état du système de commande (10) ou du système optique (100) en fonction des données de mesure (15) de l'élément d'actionnement, **caractérisé en ce que** des données d'état prétraitées sont générés en fonction
(i) des données de mesure acquises (15) de l'élément d'actionnement et d'un modèle physique (PM) et/ou d'un modèle mathématique (MM) de l'élément d'actionnement (12) ou
(ii) des données de mesure acquises (15) de l'élément d'actionnement, d'un modèle physique (PM) et/ou d'un modèle mathématique (MM) de l'élément d'actionnement (12) et du signal de commande généré (13) et
l'état du système de commande (10) ou du système optique (100) est déterminé en fonction des données d'état prétraitées (33).

13. Procédé selon la revendication 12, le système optique (100) étant soumis à une maintenance en fonction de l'état surveillé.
